(19) Europäisches Patentamt
European Patent Office
Office européen des brevets

(11) **EP 4 521 125 B1**

(12) **EUROPEAN PATENT SPECIFICATION**

(45) Date of publication and mention
of the grant of the patent:
**10.06.2026  Bulletin 2026/24**

(51) International Patent Classification (IPC):
**G01R 27/14** (2006.01)     **G01R 31/00** (2006.01)
**G01R 31/58** (2020.01)

(21) Application number: **23196564.1**

(22) Date of filing: **11.09.2023**

(52) Cooperative Patent Classification (CPC):
**G01R 31/006; G01R 27/14; G01R 31/58**

(54) **A SYSTEM AND METHOD FOR DETERMINING RESISTANCE VALUE**

SYSTEM UND VERFAHREN ZUR BESTIMMUNG EINES WIDERSTANDSWERTES

SYSTÈME ET PROCÉDÉ DE DÉTERMINATION DE VALEUR DE RÉSISTANCE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(43) Date of publication of application:
**12.03.2025  Bulletin 2025/11**

(73) Proprietors:
• **Ningbo Geely Automobile Research
& Development Co. Ltd.
Hangzhou Bay New District
Ningbo 315336 (CN)**
• **Zhejiang Geely Holding Group Co., Ltd.
Hangzhou, Zhejiang 310051 (CN)**

(72) Inventors:
• **SORANI, Heza
421 51 VÄSTRA FRÖLUNDA (SE)**
• **KELES, Nevzat
417 24 GÖTEBORG (SE)**

(74) Representative: **Zacco Sweden AB
P.O. Box 5581
Löjtnantsgatan 21
114 85 Stockholm (SE)**

(56) References cited:
**CN-A- 110 568 264     US-A1- 2022 111 807
US-B1- 6 215 313**

# Description

## TECHNICAL FIELD

The present disclosure relates to a vehicle electrical system and to a vehicle comprising such a system. The disclosure further relates to a method for determining a resistance value of the vehicle DC supply cable harness.

The system and method according to the disclosure can be arranged in a vehicle, in particular an electric vehicle having an autonomous of semi-autonomous driving system.

Moreover, even if the system and method according to the disclosure will be described primarily in relation to a car, the system and method is not restricted to this particular vehicle, but may as well be installed or implemented in another type of vehicle, such as a truck, a bus, a rail vehicle, a flying vehicle, a working vehicle such as a wheel loader or excavator, a forest vehicle such as harvesters or forwarders, a motorcycle or the like.

## BACKGROUND

In the field of vehicle electrical systems for both electrical and conventional vehicles, there is a trend towards increased electrification of vehicles. This results in increased number of electrical components in each vehicle. In addition, the number of safety critical functions, such as steering, braking and self-driving systems, are increasingly being moved from mechanical control by the driver to electrified autonomous or semi-autonomous solutions, and results in increased demand for robust and reliable operation of the electric system.

For example, increased vehicle electrification means increased current consumption and higher power request from the electrical supply system. High power requests of low-voltage loads, such as for example as electric steering, electric braking and/or self-driving systems, generally requires powerful DC/DC converter and low-voltage power supplies for handling the requested power requests without too great supply voltage reduction, which generally is a critical factor for safe and reliable operation of the electronic control units of said low-voltage loads.

In many cases the focus has been to design a system with the sufficient DC/DC power supply and/or 12V battery to deliver and provide robust power rate to the electrical loads with a stable voltage level.

However, simply using a high safety-factor of the DC/DC power supply and/or 12V battery by selecting strongly over-rated electrical devices for reducing risk for low supply voltage level is costly.

Consequently, despite the activities in the field, there is a demand for an improved vehicle electric system and method, which is capable of meeting the requirements of reliable supply voltage level and less over-rated electrical devices.

CN 110 568 264 discloses a vehicle electrical system in which the resistance of a DC supply cable harness is determined during the actual use of the vehicle.

## SUMMARY

An object of the present disclosure is to provide a system and method for determining resistance value of a cable harness, such that the vehicle electric system can be monitored and thereby providing vehicle electric system that is capable of meeting the requirements of reliable supply voltage level and less over-rated electrical devices.

According to a first aspect of the present disclosure, a vehicle electrical system comprises: a vehicle low-voltage electrical circuit having a low-voltage energy storage unit connected to a first low-voltage load via a battery contactor and a first section of a vehicle DC supply cable harness; a cable resistance measurement arrangement having a dedicated electrical power storage and a switching arrangement configured for selective connection of the dedicated electrical power storage with the first section of a vehicle DC supply cable harness; and an electrical control system configured for controlling operation of the switches of the switching arrangement and the battery contactor; wherein the electric control system is configured to perform a resistance measurement of the first section of the vehicle DC supply cable harness by: setting the battery contactor in open state for interrupting electrical power supply from the low-voltage energy storage unit to the first low-voltage load; controlling the switching arrangement for temporarily connecting the first section of a vehicle DC supply cable harness with the dedicated electrical power storage for generating a measurement current through the first section of the vehicle DC supply cable harness; and determining a resistance value of the first section of the vehicle DC supply cable harness based on the measurement current level.

According to a second aspect of the present disclosure, a method for determining a resistance value of the vehicle DC supply cable harness of a vehicle electrical system, wherein the vehicle electrical system comprises: a vehicle low-voltage electrical circuit having a low-voltage energy storage unit connected to a first low-voltage load via a battery contactor and a first section of a vehicle DC supply cable harness; a cable resistance measurement arrangement having a dedicated electrical power storage and a switching arrangement configured for selective connection of the dedicated electrical power storage with the first section of a vehicle DC supply cable harness; wherein the method comprises: setting the battery contactor in open state for interrupting electrical power supply from the low-voltage energy storage unit to the first low-voltage load; controlling the switching arrangement for temporarily connecting the first section of a vehicle DC supply cable harness with the dedicated electrical power storage for generating a measurement current through the first section of the vehicle DC supply cable harness; and determining a resistance value of the first section of the vehicle DC supply cable harness based on the measurement current level.

There is an important parameter between the low-voltage electrical loads and the low-voltage power source(s) of virtually all vehicle electrical systems, namely the cable harness the conveys the electrical power from the power source(s) to the electrical loads. The cable harness, also referred to herein as DC supply cable harness, has a resistance/impedances that causes a voltage drop. This voltage drop, which is caused by the cable harness resistance/ impedances, is generally only taken into account at the design phase of the vehicle electrical system, i.e. at the beginning of the project when designing of the power distribution and power supply is defined. At this design stage, the cable resistance is calculated based on various physical parameters, such as the material used, cross section area and length of the DC supply cable harness. Thereafter, this cable harness resistance value is set as a fixed parameter, and there is no follow up, monitoring or detection of the vehicle electrical system to analyse how this cable harness resistance value is varying over the time, and how this will affect the voltage quality and voltage drops based on the current flowing through it.

The present disclosure introduces a solution to periodically obtain the resistance value in the cable harness, such that the risk for voltage drops caused by increased cable harness resistance, for example due to aging, that can lead to unacceptable low supply voltage on affected/safety critical electrical load, is eliminated or at least strongly reduced.

Depending on the component/ECU and its safety critical functionality, this cable harness resistance measurement can be applied and designed to detect any risk for high voltage drops that can lead to violation against safety related functionality.

Further advantages are achieved by implementing one or several of the features of the dependent claims.

In some example embodiments, that may be combined with any one or more of the above-described embodiments, the vehicle low-voltage electrical circuit further has second low-voltage load connected to the low-voltage energy storage unit via the battery contactor and a second section of the vehicle DC supply cable harness, wherein the switching arrangement is configured for selective connection of the dedicated electrical power storage with the second section of the vehicle DC supply cable harness, wherein the electric control system is configured to perform a resistance measurement of the second section of the vehicle cable harness by: controlling the switching arrangement for temporarily connecting the second section of a vehicle DC supply cable harness with the dedicated electrical power storage for generating a measurement current through the second section of the vehicle DC supply cable harness; and determining a resistance value of the second section of the vehicle DC supply cable harness based on the measurement current level through the second section. The electrical system is thus capable to detecting the resistance values of a plurality of individual sections of the vehicle DC supply cable harness, thereby enabling the system to handle potential voltage drops in a more refined manner, for example by temporarily shutting down non-critical electrical loads, or the like, thereby enabling prolonged use of the vehicle.

In some example embodiments, that may be combined with any one or more of the above-described embodiments, the electric control system comprises a dedicated electronic measuring control unit that is part of the cable resistance measurement arrangement, and wherein electronic measuring control unit is configured for controlling operation of the switches of the switching arrangement, and for determining said resistance value of the vehicle DC supply cable harness. A dedicated electronic measuring control unit enables a more distributed system, and also enables interruption of electrical power supply from the low-voltage energy storage unit, which feeds power to the master electronic control unit.

In some example embodiments, that may be combined with any one or more of the above-described embodiments, the electronic measuring control unit is powered by the dedicated electrical power storage. This provides a flexible and independent unit that has internal power supply and internal processing power.

In some example embodiments, that may be combined with any one or more of the above-described embodiments, the cable resistance measurement arrangement further comprises a charging contactor for selectively connecting the dedicated electrical power storage with the low-voltage energy storage unit for charging of the dedicated electrical power storage. Thereby, keeping the dedicated electrical power storage at a fully charged level, ready for being connected to the vehicle DC supply cable harness for detecting resistance value, or simply as backup to the low-voltage energy storage unit, is simplified.

In some example embodiments, that may be combined with any one or more of the above-described embodiments, the negative pole of the dedicated electrical power storage is connected to ground point via a ground contactor, wherein operation of the ground contactor is controlled by the electronic measuring control unit, and wherein the electronic measuring control unit is configured to set the ground contactor in open state when a resistance measurement of a section of the vehicle DC supply cable harness is performed. Thereby, it is ensured that all current flows through the desired section of the DC supply cable harness, and not through a ground connection.

In some example embodiments, that may be combined with any one or more of the above-described embodiments, the electronic measuring control unit is configured to set the ground contactor in closed state during charging of the dedicated electrical power storage.

In some example embodiments, that may be combined with any one or more of the above-described embodiments, the resistance value is determined: by registering the measurement current level (I) flowing through the section of the vehicle DC supply cable harness, and the voltage level (U) applied to said the section of the vehicle DC supply cable harness, and determining the resistance value based on equation $R = \frac{U}{I}$.

In some example embodiments, that may be combined with any one or more of the above-described embodiments, the resistance value is determined based on registered voltage between midpoints of the Wheatstone bridge that is connected to the section of a vehicle DC supply cable harness and the dedicated electrical power storage. Thereby, only voltage sensing is required, and no current sensing.

In some example embodiments, that may be combined with any one or more of the above-described embodiments, the resistance value is determined by adjusting the resistance level of a variable resistance ($R_2$) of the Wheatstone bridge, such that a measured voltage ($V_G$) between midpoints of the Wheatstone bridge is zero. At this point, resistance value ($R_x$) is derived by $R_x = \frac{R_3 R_2}{R_1}$.

In some example embodiments, that may be combined with any one or more of the above-described embodiments, the resistance value is determined by registering the voltage ($V_G$) between midpoints of the Wheatstone bridge and calculating resistance value ($R_x$) based on $V_G = V \times \left( \frac{R_1}{R_1 + R_2} + \frac{R_3}{R_3 + R_x} \right)$, wherein V is the voltage level supplied to the Wheatstone bridge, and wherein the resistance values of R1, R2, R3 are known/predetermined. Determining the internal resistance value of a section of a vehicle DC supply cable harness is simplified, and the cable resistance measurement arrangement is less costly, if the variable resistance R2 can be replaced with a resistor having a fixed and predetermined resistance value.

In some example embodiments, that may be combined with any one or more of the above-described embodiments, the charging contactor is connected to a first node point of the vehicle DC supply cable harness located adjacent the low-voltage energy storage unit, wherein the switching arrangement comprises a first switch that is connected to a second node point of the vehicle DC supply cable harness located adjacent the first low-voltage load, wherein the first and second node points define the first section of the vehicle DC supply cable harness, wherein the electric control system is configured to generate the measurement current through the first section of the vehicle DC supply cable harness by setting the charging contactor and the first switch in a closed state, such that a measurement current flows from the dedicated electrical power storage, through the charging contactor, the first section of the vehicle DC supply cable harness, the first switch, and back to the dedicated electrical power storage. By using the charging line and the charging contactor during resistance measurement, the charging line and the charging contactor is dual functionality: Keeping the dedicated electrical power storage fully charged and ready for use, and measurement of the resistance level of the first sections of the DC supply cable harness.

In some example embodiments, that may be combined with any one or more of the above-described embodiments, the switching arrangement comprises a first switch that is connected to a first node point of the vehicle DC supply cable harness located adjacent the low-voltage energy storage unit, and a second switch that is connected to a second node point of the vehicle DC supply cable harness located adjacent the first low-voltage load, wherein the first and second node points define the first section of the vehicle DC supply cable harness, wherein the electric control system is configured to generate the measurement current through the first section of the vehicle DC supply cable harness by setting the charging contactor in open state and setting the first and second switches in a closed state, such that a measurement current flows from the dedicated electrical power storage, through the second switch, the first section of the vehicle DC supply cable harness, the first switch, and back to the dedicated electrical power storage.

In some example embodiments, that may be combined with any one or more of the above-described embodiments, the electric control system is configured to use the dedicated electrical power storage as a redundant power supply for the vehicle low-voltage electrical circuit, in particular for the first low-voltage load, in case of failure or low charge level of the low-voltage energy storage unit. This results in improved operational reliability.

In some example embodiments, that may be combined with any one or more of the above-described embodiments, the cable resistance measurement arrangement is integrated in the first low-voltage load. This may provide a more compact and integrated design. Moreover, this design may also be more cost-effective in case the cable resistance measurement arrangement and first low-voltage load can share the same electronic control unit.

In some example embodiments, that may be combined with any one or more of the above-described embodiments, the vehicle electrical system further comprises: a high-voltage electrical storage system; a DC/DC converter connected to the high-voltage electrical storage system and to the vehicle low-voltage electrical circuit and configured for supplying electrical power from the high-voltage electrical storage system to the vehicle low-voltage electrical circuit, and to an electrical vehicle propulsion motor connected to the high-voltage electrical storage system via a motor controller. Monitoring of resistance values of the vehicle DC supply cable harness is particularly important for electric vehicles that lack a combustion engine driven electrical generator.

In some example embodiments, that may be combined with any one or more of the above-described embodiments, the vehicle electrical system further comprises: a redundant vehicle low-voltage electrical circuit having a redundant low-voltage energy storage unit connected to a redundant first low-voltage load via a battery contactor and a first section of a redundant vehicle DC supply cable harness; an additional cable resistance measurement arrangement having an additional dedicated electrical power storage and an additional switching arrangement configured for selective connection of the additional dedicated electrical power storage with a first section of the redundant vehicle DC supply cable harness; wherein the electrical control system is configured for controlling operation of the switches of the additional switching arrangement and the battery contactor of the redundant low-voltage energy storage unit; wherein the electric control system is configured to perform a resistance measurement of the first section of the redundant vehicle DC supply cable harness by: setting the battery contactor of the redundant low-voltage energy storage unit in open state for interrupting electrical power supply from the redundant low-voltage energy storage unit to the redundant first low-voltage load; controlling the additional switching arrangement for temporarily connecting the first section of a redundant vehicle DC supply cable harness with the additional dedicated electrical power storage for generating a measurement current through the first section of the redundant vehicle DC supply cable harness; and determining a resistance value of the first section of the redundant vehicle DC supply cable harness based on the measurement current level.

In some example embodiments, that may be combined with any one or more of the above-described embodiments, the vehicle electrical system comprises a redundant vehicle low-voltage electrical circuit having a redundant low-voltage energy storage unit connected to a redundant first low-voltage load via a battery contactor and a first section of a redundant vehicle DC supply cable harness, wherein the switching arrangement configured for selective connection of the dedicated electrical power storage with a first section of the redundant vehicle DC supply cable harness, and wherein the electric control system is configured to perform a resistance measurement of the first section of the redundant vehicle DC supply cable harness by: setting the battery contactor of the redundant low-voltage energy storage unit in open state for interrupting electrical power supply from the redundant low-voltage energy storage unit to the redundant first low-voltage load; controlling the switching arrangement for temporarily connecting the first section of a redundant vehicle DC supply cable harness with the dedicated electrical power storage for generating a measurement current through the first section of the redundant vehicle DC supply cable harness; and determining a resistance value of the first section of the redundant vehicle DC supply cable harness based on the measurement current level. Using the same cable resistance measurement arrangement for detecting resistance values of both the low-voltage DC supply cable harness and redundant low-voltage DC supply cable harness provides a cost-effective design.

In some example embodiments, that may be combined with any one or more of the above-described embodiments, the disclosure relates to a vehicle comprising the vehicle electrical system according to any of the one or more embodiments described above.

In some example embodiments, that may be combined with any one or more of the above-described embodiments, the vehicle low-voltage electrical circuit further has second low-voltage load connected to the low-voltage energy storage unit via the battery contactor and a second section of the vehicle DC supply cable harness, and the switching arrangement is configured for selective connection of the dedicated electrical power storage with the second section of the vehicle DC supply cable harness, wherein the method described above further comprises: controlling the switching arrangement for temporarily connecting the second section of a vehicle DC supply cable harness with the dedicated electrical power storage for generating a measurement current through the second section of the vehicle DC supply cable harness; and determining a resistance value of the second section of the vehicle DC supply cable harness based on the measurement current level through the second section.

In some example embodiments, that may be combined with any one or more of the above-described embodiments, the vehicle electrical system further comprises: a redundant vehicle low-voltage electrical circuit having a redundant low-voltage energy storage unit connected to a redundant first low-voltage load via a battery contactor and a first section of a redundant vehicle DC supply cable harness; a DC/DC converter connected to the high-voltage electrical storage system and to the redundant vehicle low-voltage electrical circuit, and configured for supplying electrical power from the high-voltage electrical storage system to the redundant vehicle low-voltage electrical circuit; wherein the switching arrangement configured for selective connection of the dedicated electrical power storage with a first section of the redundant vehicle DC supply cable harness; and wherein the method comprises: setting the battery contactor of the redundant low-voltage energy storage unit in open state for interrupting electrical power supply from the redundant low-voltage energy storage unit to the redundant first low-voltage load; controlling the switching arrangement for temporarily connecting the first section of a redundant vehicle DC supply cable harness with the dedicated electrical power storage for generating a measurement current through the first section of the redundant vehicle DC supply cable harness; and determining a resistance value of the first section of the redundant vehicle DC supply cable harness based on the measurement current level.

Further features and advantages of the disclosure will become apparent when studying the appended claims and the following description. The skilled person in the art realizes that different features of the present disclosure may be combined to create embodiments other than those explicitly described hereinabove and below, without departing from the scope of the present disclosure.

BRIEF DESCRIPTION OF DRAWINGS

The system and method according to the disclosure will be described in detail in the following, with reference to the attached drawings, in which

| | |
|---|---|
| Fig. 1 | shows schematically a side-view of a battery electrical vehicle that may have the system and method according to the disclosure implemented therein, |
| Fig. 2 | shows an example layout of the electric system of the vehicle of figure 1, |
| Fig. 3 | shows an example layout of the electric system of the conventional combustion engine vehicle, |
| Fig. 4 | shows an example embodiment of the cable resistance measurement arrangement, |
| Fig. 5 | shows charging of the dedicated electrical power storage, |
| Fig. 6 | shows detection of resistance of the first section of the cable harness, |
| Fig. 7 | shows detection of resistance of the second section of the cable harness |
| Fig. 8A | shows cable resistance measurement arrangement having Wheatstone bridge, |
| Fig. 8B | shows simplified view of Wheatstone bridge of figure 8A, |
| Fig. 9 | shows another example embodiment of the cable resistance measurement arrangement, |
| Fig. 10 | shows cable resistance measurement using the 4-wire method, |
| Fig. 11 | shows the other example embodiment of the cable resistance measurement arrangement combined with Wheatstone bridge, |
| Fig. 12 | shows cable resistance measurement arrangement integrated in low-voltage load, |
| Fig. 13 | shows cable resistance measurement arrangement with ground contactor, |
| Fig. 14 | shows an example embodiment of electrical system comprising both high-voltage side and redundant low-voltage electrical circuits, with one cable resistance measurement arrangement connected to each low-voltage electrical circuit, |
| Fig. 15 | shows an example embodiment of electrical system comprising both high-voltage side and redundant low-voltage electrical circuits, with a single cable resistance measurement arrangement connected to both low-voltage electrical circuits, |
| Fig. 16 | shows the basic step of a method according to disclosure. |

DESCRIPTION OF EXAMPLE EMBODIMENTS

Various aspects of the disclosure will hereinafter be described in conjunction with the appended drawings to illustrate and not to limit the disclosure, wherein like designations denote like elements, and variations of the described aspects are not restricted to the specifically shown embodiments, but are applicable on other variations of the disclosure.

The vehicle electrical system and method for determining a resistance value of the vehicle DC supply cable harness of a vehicle electrical system according to the present disclosure may be implemented in various types of vehicle electrical systems. For example, it may be implemented in battery electric vehicles, hybrid electric vehicles or more conventional combustion engine vehicles.

As an example, the vehicle electrical system and associated method of the present disclosure may be implemented in a battery electric or hybrid electric vehicle having an electric circuit layout similar to the schematic illustration of figures 1 and 2, or implemented in a more conventional combustion engine powered vehicle having an electric circuit layout similar to that schematically illustrated in figure 3.

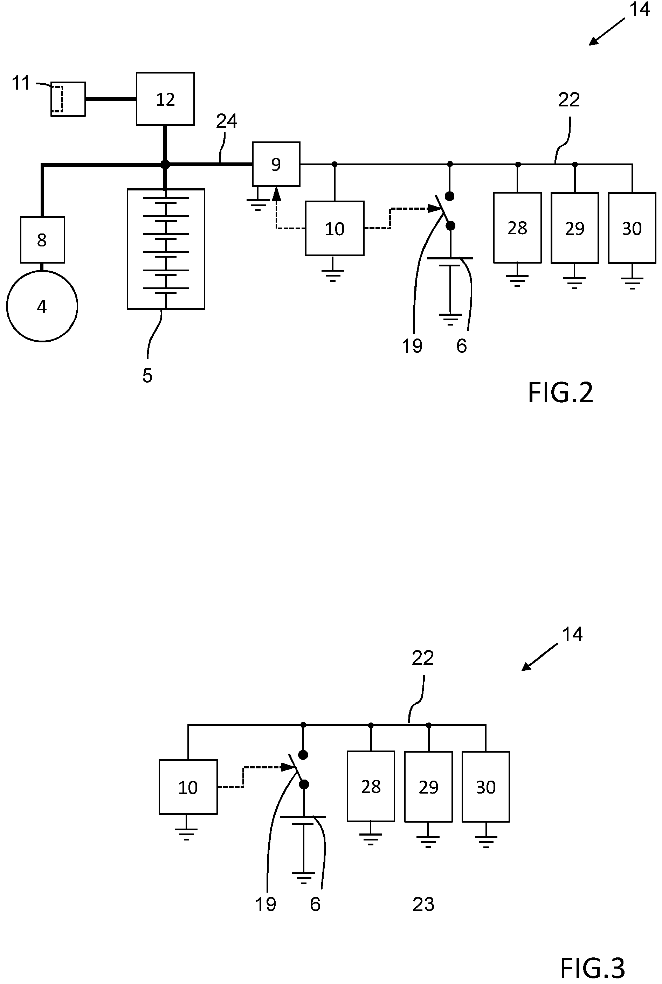

The electric circuit layout of figures 2 and 3 include a vehicle low-voltage electrical circuit having safety critical low-voltage loads 28-30 in form of for example an electric steering module, an electric braking module, or the like, thereby rendering detection of a resistance value of the vehicle DC supply cable harness particularly relevant. However, system failure of vehicle ECU's due to under-voltage caused by unsatisfactory power supply performance is a potential problem that may occur in nearly any type of modern vehicle having a vast array of electric appliances, and not only vehicles with safety critical loads. In other words, the vehicle electrical system and associated method of the present disclosure may be advantageously implemented in nearly any type of vehicle electric systems, also those without safety critical low-voltage loads.

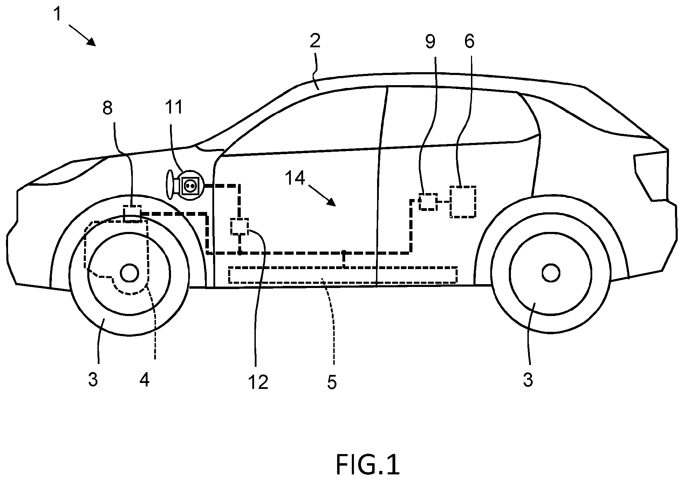

For setting the electrical system and associated method in a context, figure 1 schematically shows a side view of an electrical vehicle 1, such as a car, that may include the electrical system according to the disclosure. The vehicle may for example have a body 2, front and rear wheels 3 and an electrical system 14 according to the present disclosure. The electrical system 14 may for example comprises an electric propulsion motor 4 drivingly connected to one or more wheels 3, a high-voltage (HV) electrical storage system 5, and a vehicle low-voltage electrical circuit having a low-voltage (LV) energy storage unit 6.

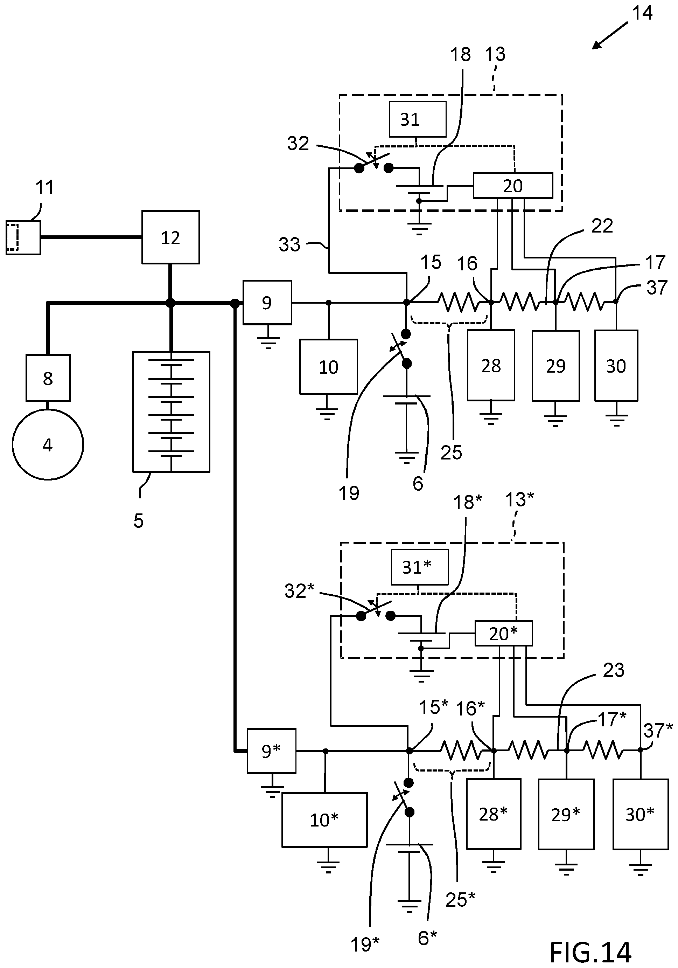

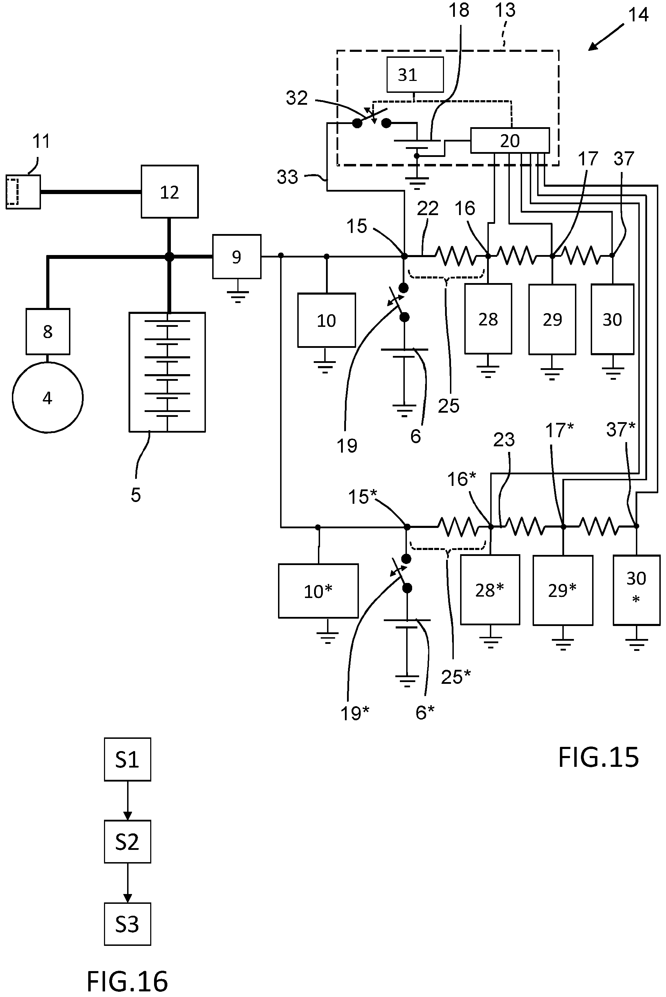

In some example embodiments, as schematically illustrated in figures 14 and 15, the electrical system 14 may additionally include a redundant vehicle low-voltage electrical circuit having a redundant a low-voltage (LV) energy storage unit. The provision of two parallel connected low-voltage electrical circuits provide improved fault tolerance against various failure scenarios, thereby enabling increased operational safety to various safety critical low-voltage loads that are connected to said low-voltage electrical circuits.

The electric propulsion motor 4 may for example be a single-phase or multi-phase AC motor or a DC-motor, and the vehicle 1 may include more than one propulsion motor 4 for enabling for example all-wheel drive, torque vectoring, wheel hub motors, or the like.

The electric propulsion motor 4 is connected to the high-voltage electrical storage system 5 via a motor controller 8, such as for example an inverter.

The HV electrical storage system 5 may include an electric battery having a plurality of electrochemical cells. For example, the HV battery may be a Lithium-Ion battery having a certain nominal voltage level, such as for example at least 60 Volt, specifically at least 200V. In some example embodiments, the nominal voltage level of the HV battery be in the range of 200 - 2000 V. The HV electrical storage system 5 may additionally, or alternatively, include one or more super capacitors.

The LV energy storage unit 6 may for example include a battery, such as a 12 volt battery, or alternatively having another voltage level, such as for example in the range of 12 - 59 volt. The LV battery 6 may for example be a Lead-Acid battery, Lithium-Ion battery, or some other type of battery. The LV energy storage unit 6 may additionally, or alternatively, include one or more super capacitors.

The high-voltage electrical storage system 5 may be connected to the LV energy storage unit 6 via a DC/DC converter 9. Thereby, the low-voltage energy storage unit 6 may be charged using electrical power from the HV electrical storage system 5, and possibly also oppositely.

The vehicle may further comprises an on-board charging inlet 11 and an on-board charger 12. The on-board charging inlet 11 may for example be an electric socket easily accessibly on the outside of the vehicle 1 and configured to receive an electric charging plug or charging connector of a stationary external charging unit. Such stationary charging units are for example available at public charging stations or at the home, and they are connected to the electric power grid. Alternatively, the on-board charging inlet may be part of a wire-less charging pad arrangement configured for receiving electric power from the electric grid wirelessly, e.g. by inductive power transfer from a stationary ground pad to vehicle mounted receiving pad.

The on-board charger 12 is operably connected to the on-board charging inlet 11 and to the high-voltage electrical storage system 5 for converting the received electrical power from the grid to a form suitable for charging of the high-voltage electrical storage system 5 and LV energy storage unit 6.

Figure 2 shows schematically a more detailed view of an example embodiment of the on-board electrical system 14. The on-board electrical system 14 comprises a high-voltage electrical storage system 5. The on-board electrical system 14 further comprises a LV energy storage unit 6 system connected in series with a battery contactor 19, i.e. an electrical switch.

A master electronic control unit 10 may be arranged for controlling operation of the battery contactor 19.

The low-voltage load 28-30 in form of a braking module may for example include an electronic braking controller and/or a braking actuator. The low-voltage load 28-30 in form of a steering module may for example include an electronic steering controller and/or a steering actuator.

In the example embodiment of figure 2, the master electronic control unit ECU may be configured to control operation also of the DC/DC converter 9.

In other words, the low-voltage energy storage unit 6 may be connected to, and configured to supply electrical power to, a low-voltage DC bus in form of a low-voltage DC supply cable harness 22, and various electrical low-voltage loads 28-30 may be connected to the low-voltage DC supply cable harness 22, such as a first low-voltage load 28, a second low-voltage load 29 and a third low-voltage load 30.

Other low-voltage electrical loads may also be connected to the l low-voltage DC supply cable harness 22.

As mentioned above, the on-board electrical system 14 further comprises a DC/DC converter 9 operably connecting the high-voltage electrical storage system 5 with the low-voltage DC supply cable harness 22. Furthermore, the DC/DC converter 9 may be connected with the high-voltage electrical storage system 5 via a high-voltage DC bus 24.

The master electronic control unit 9 may be configured for controlling operation of the battery contactor 19 of the low-voltage power supply 18.

With reference to figures 14-15, the vehicle may according to alternative example embodiments be additionally equipped with a redundant low-voltage energy storage unit for providing a redundant low-voltage power supply. This may be appropriate or even required when the vehicle includes one or more drive-by-wire systems, because such systems may need redundant low-voltage power supply to ensure sufficient and/or regulated driving safety. Furthermore, self-driving driving vehicles may also require redundant low-voltage power supply for certain safety critical driving systems, such as for example electric steering system, electric braking system, obstacle detection system, navigation system, electronic controllers, the like.

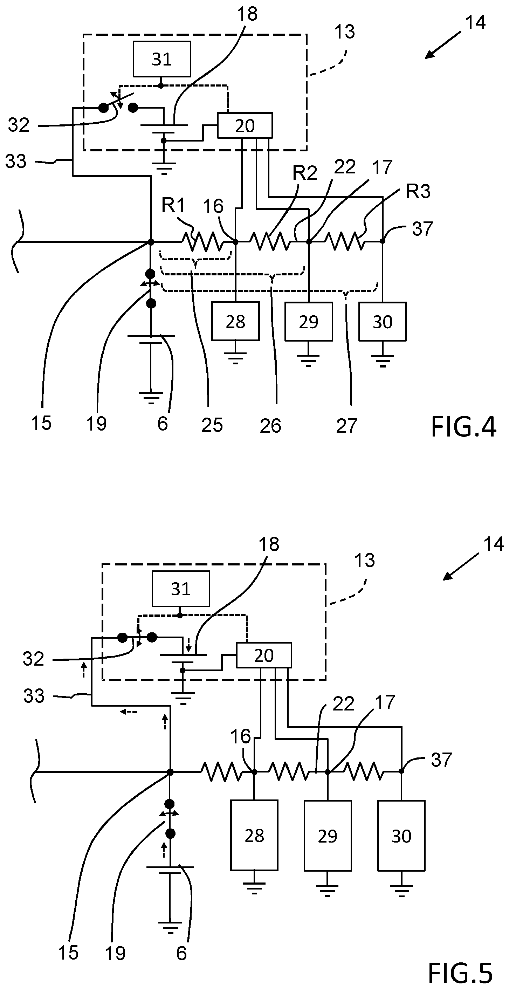

An example embodiment of the vehicle electrical system 14 according to the present disclosure is hereinafter described with reference to figure 4. The vehicle electrical system 14 comprises a vehicle low-voltage electrical circuit having a low-voltage energy storage unit 6 connected to a first low-voltage load 28 via a battery contactor 19 and a first section 25 of a vehicle DC supply cable harness 22. The vehicle electrical system 14 further comprises a cable resistance measurement arrangement 13 having a dedicated electrical power storage 18 and a switching arrangement 20 configured for selective connection of the dedicated electrical power storage 18 with the first section 25 of a vehicle DC supply cable harness 22. In addition, the vehicle electrical system 14 comprises an electrical control system configured for controlling operation of the switches of the switching arrangement 20 and the battery contactor 19.

The electric control system is configured to perform a resistance measurement of the first section 25 of the vehicle DC supply cable harness 22 by: setting the battery contactor 19 in open state for interrupting electrical power supply from the low-voltage energy storage unit 6 to the first low-voltage load 28, controlling the switching arrangement 20 for temporarily connecting the first section 25 of the vehicle DC supply cable harness 22 with the dedicated electrical power storage 18 for generating a measurement current through the first section 25 of the vehicle DC supply cable harness 22, and determining a resistance value of the first section 25 of the vehicle DC supply cable harness 22 based on the measurement current level.

Thereby, the risk for unacceptable low supply voltage levels to the low-voltage load(s), caused by increased cable harness resistance over time, for example due to aging, is eliminated or at least strongly reduced. In addition, the vehicle electric system may be designed without a strongly over-rated battery capacity of the low-voltage energy storage unit 6, while still being capable of meeting the requirements of reliable supply voltage level.

This is performed by regularly or periodically detecting a resistance and/or impedances value of the DC supply cable harness, and controlling the overall electrical system, for example by means of fault manager, for ensuring that all critical electrical low-voltage loads always are supplied with sufficient power level.

Such a fault manager may for example upon detection of problematic high resistance value of any section of the vehicle DC supply cable harness be configured to alert the vehicle user, manufacturer and/or fleet owner about the current status of the vehicle. The fault manager may for example also in critical driving situations instruct the vehicle electric control system shutdown one or more non-critical electrical low-voltage loads, for reducing the likelihood of a under voltage to a safety critical electrical low-voltage load.

The low-voltage energy storage unit 6 is for example an electrical battery, such as a lead-acid or Li-Ion battery. It may for example have a voltage level of about 10-26 Volt, in particular 12-14 Volt.

The battery contactor 19 is for example an electrically-controlled switch or an electrically-controlled relay.

The first section 25 of the vehicle DC supply cable harness 22 is for example defined by a first node point 15 and a second node point 16 of the vehicle DC supply cable harness 22, wherein the first node point 15 is located relatively close to the battery contactor 19, and wherein the second node point 16 of the vehicle DC supply cable harness 22 is located relatively close to the first low-voltage load 28.

The dedicated electrical power storage of the cable resistance measurement arrangement may for example be an electrical battery, such as a lead-acid or Li-Ion battery. In some example embodiments, the dedicated electrical power storage may have a relatively low voltage level, such as for example 6 - 12 Volt, and with a relatively low capacity (Ampere hour), because the dedicated electrical power storage may be designed to only generate a measurement current through a section of the vehicle DC supply cable harness. However, in other example embodiments, the dedicated electrical power storage may have a slightly higher voltage level, such as for example about 10-26 Volt, in particular 12-14 Volt.

Furthermore, in case the dedicated electrical power storage is configured for also other functionalities, such as power-backup for the low-voltage energy storage unit 6 or the like, the dedicated electrical power storage may have a relatively large capacity (Ampere hour), such that the dedicated electrical power storage can operate one or more safety critical loads of the vehicle low-voltage electrical circuit, in case of failure of the low-voltage energy storage unit 6, or the like.

The switching arrangement may for example include a set of electrically controlled switches, such as semiconductor based switches or relays, or a combination thereof.

For avoiding interference from other electrical power sources during generation of the a measurement current through the first section of the vehicle DC supply cable harness and detection of the resistance value of the relevant section of the vehicle DC supply cable harness, the battery contactor is set in in open state for interrupting electrical power supply from the low-voltage energy storage unit to the first low-voltage load. In case the first low-voltage load is connected also to other power sources, such as for example a DC/DC converter or the like, electrical power supply also from these power supplies is interrupted during the resistance measurement phase.

The vehicle electrical control system typically includes a plurality of electric control units (ECU's) operating a collaboration with each other. For example, there may be a relatively high-capacity Master ECU configured for controlling one or more distributed low-capacity ECU's via a vehicle data communication bus.

In some example embodiments, the electric control system comprises a dedicated electronic measuring control unit 31 that is part of the cable resistance measurement arrangement 13, and wherein the electronic measuring control unit 31 is configured for controlling operation of the switches of the switching arrangement 20, and for determining said resistance value of the vehicle DC supply cable harness 22. Such distributed layout of the electric control system has many advantages, such as improved failure handling, reliability, and efficiency.

In some example embodiments, the electronic measuring control unit 31 is powered by the dedicated electrical power storage 18. This simplifies power supply of the cable resistance measurement arrangement 13 in view of the interruption of the power supply from the first low-voltage load, and possibly also DC/DC converter, during the resistance measurement phase.

In some example embodiments, the cable resistance measurement arrangement 13 further comprises a charging contactor 32 for selectively connecting the dedicated electrical power storage 18 with the low-voltage energy storage unit 6, or another part of the vehicle DC supply cable harness 22, for enabling charging of the dedicated electrical power storage.

In other words, when charging of the dedicated electrical power storage 18 is necessary, the charging contactor 32 is closed for establishing a connecting between the positive terminal of the low-voltage energy storage unit 6 with the positive terminal of the dedicated electrical power storage 18. A DC/DC converter may be required between the low-voltage energy storage unit 6 and the dedicated electrical power storage 18 in case they have different voltage rating.

A electric charging line 33, e.g. electrical conductor, connects the low-voltage energy storage unit 6 with the dedicated electrical power storage 18 when the charging contactor 32 is set in closed state, i.e. conducting state.

Figure 5 schematically illustrates a charging scenario of the dedicated electrical power storage 18, in a scenario where the low-voltage energy storage unit 6 and the dedicated electrical power storage 18 has the same voltage rating. During charging, both the battery contactor 19 and charging contactor 32 are set in closed operating state, such that an electrical connection is established between the positive terminal of the low-voltage energy storage unit 6 and the positive terminal of the dedicated electrical power storage 18. Simultaneously, the negative pole of each of the low-voltage energy storage unit 6 and the dedicated electrical power storage 18 is connected to ground point, thereby enabling a charging current path from the low-voltage energy storage unit 6 to the dedicated electrical power storage 18, as schematically illustrated in figure 5 by dotted current flow arrows.

Operation of the charging contactor 32 is for example controlled by the electronic measuring control unit 31. This simplifies control of the charging contactor 32 during time period of interrupted power supply from the first low-voltage load, and possibly also DC/DC converter, if such control is required during the resistance measurement phase.

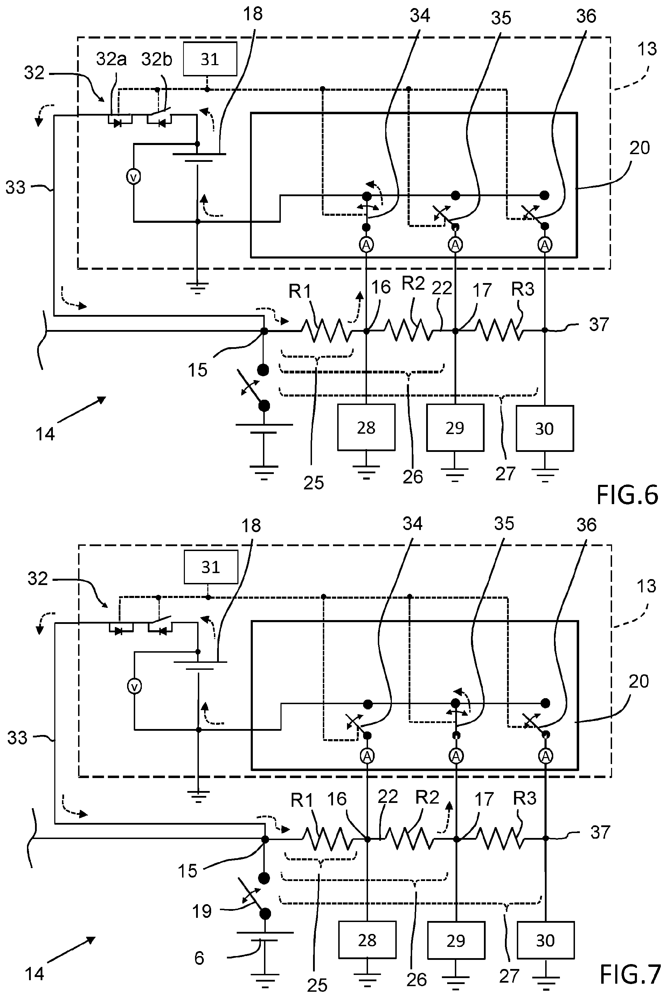

Figure 6 schematically shows an example operating embodiment of the vehicle electrical system during a resistance measurement phase. In the example embodiment, the electric charging line 33 is used also during the resistance measurement phase, i.e. the electric charging line 33 has dual functionality.

Specifically, according to this example embodiment, the charging contactor 32 is connected to the first node point 15 of the vehicle DC supply cable harness 22, wherein the first node point 15 is located adjacent the low-voltage energy storage unit. The switching arrangement 20 comprises a first switch 34 that is connected to a second node point 16 of the vehicle DC supply cable harness 22, wherein the second node point 16 is located adjacent the first low-voltage load 28, and wherein the first and second node points 15, 16 jointly define the first section 25 of the vehicle DC supply cable harness 22. The electric control system is configured to generate the measurement current through the first section 25 of the vehicle DC supply cable harness 22 by setting the charging contactor 32 and the first switch 34 in a closed state, such that a measurement current flows from the dedicated electrical power storage 18, through the charging contactor 32, the first section of the vehicle DC supply cable harness 25, the first switch 34, and back to the dedicated electrical power storage 18.

In other words, according to some example embodiments of the resistance measurement phase, measurement current is controlled to flow from the positive terminal of the dedicated electrical power storage 18, past the charging contactor 32, through the charging line 33, past the first node point 15, the first section of the vehicle DC supply cable harness, and the second node point 16, past the first switch 34 and back to the negative terminal of the dedicated electrical power storage 18.

In figures 4-8, 12-15, the cable resistance of the first section 25 of the vehicle DC supply cable harness 22, as defined by the first and second node points 15, 16, is schematically illustrated as a first resistor R1. The cable resistance of the second section 26 of the vehicle DC supply cable harness 22, as defined by the first and third node points 15, 17, is schematically illustrated as a combination of the first resistor R1 and a second resistor R2. Similarly, the cable resistance of the third section 27 of the vehicle DC supply cable harness 22, as defined by the first and fourth node points 15, 37, is schematically illustrated as a combination of the first resistor R1, second resistor R2 and the third resistor R3.

According to some example embodiments, as schematically shown in figures 6 to 8, the charging contactor 32 may be implemented as a bidirectional switch formed by using two oppositely arranged power transistors 32a, 32b, thereby providing both reverse and forward voltage-blocking capabilities by having their body diodes facing opposite directions. Moreover, by designing and implementing the switching units 48, 49 with a plurality of power transistors arranged in a Back-To-Back layout with independent control, high ASIL integrity and operational safety is provided by monitoring and diagnostics if any error would occur. However, the charging contactor 32 may alternatively be implemented using a single power transistor, for example in designs when no bidirectional functionality is required, or when reverse voltage-blocking capability is provided by other means.

The charging contactor 32 is herein referred to as a single switch even the switch in some embodiments may be implemented by two oppositely arranged transistors 32a, 32b.

The switching arrangement 20 may include a plurality of switches, each connecting different parts of the vehicle electrical system for enabling cable resistant measurement of a plurality of individual sections of the vehicle DC supply cable harness, one by one, in any selected sequential order. For example, in the example embodiment of figure 6, the switching arrangement 20 comprises also a second switch 35 and a third switch 36, wherein the first switch 34 is connected to the second node point 16 and the negative pole of the dedicated electrical power storage 18, wherein the second switch 35 is connected to a third node point 17 and the negative pole of the dedicated electrical power storage 18, and wherein the third switch 36 is connected to a fourth node point 37 and the negative pole of the dedicated electrical power storage 18.

As a result, closure of the first switch 34, while keeping second and third switches 35, 36 closed, enables detection of cable resistance of the first section 25 of the vehicle DC supply cable harness 22. Closure of the second switch 35, while keeping first and third switches 34, 36 closed, enables detection of the cable resistance of the second section 26 of the vehicle DC supply cable harness 22. Similarly, closure of the third switch 36, while keeping first and second switches 34, 35 closed, enables detection of the cable resistance of the third section 27 of the vehicle DC supply cable harness 22. Thereby, the dedicated electronic measuring control unit 31 can easily register and monitor the individual cable resistance value between each node points individually, based on a predetermined layout of the vehicle low-voltage electrical circuit 22.

Figure 7 schematically illustrates an example embodiment of a vehicle electrical system during detection of the cable resistance of the second section 26 of the vehicle DC supply cable harness 22. In other words, the vehicle low-voltage electrical circuit 22 further has second low-voltage load 29 connected to the low-voltage energy storage unit 6 via the battery contactor 19 and a second section 26 of the vehicle DC supply cable harness 22. The switching arrangement is configured for selective connection of the dedicated electrical power storage 18 with the second section 26 of the vehicle DC supply cable harness 22. Moreover, the electric control system is configured to perform a resistance measurement of the second section of the vehicle cable harness by: controlling the switching arrangement for temporarily connecting the second section of a vehicle DC supply cable harness with the dedicated electrical power storage for generating a measurement current through the second section of the vehicle DC supply cable harness, and subsequently determining a resistance value of the second section of the vehicle DC supply cable harness based on the measurement current level through the second section.

In other words, according to some example embodiments of the resistance measurement phase, measurement current is controlled to flow from the positive terminal of the dedicated electrical power storage 18, past the charging contactor 32, through the charging line 33, past the first node point 15, through the second section 26 of the vehicle DC supply cable harness up to the third node point 17, past the second switch 35 and back to the negative terminal of the dedicated electrical power storage 18.

In the layout of the example embodiment of the electric system according to figure 7, the resistance value of the second section of the vehicle DC supply cable corresponds to the combined resistance of resistances R1 and R2.

The battery contactor is maintained in open state for interrupting electrical power supply from the low-voltage energy storage unit to the second low-voltage load during cable resistance measuring. Similarly, also power from the DC/DC converter to second low-voltage load is interrupted.

The resistance value of a certain section of the vehicle DC supply cable harness 22 may for example be determined using ohms law. In other words, the resistance value may be determined by registering the measurement current level (I) flowing through the relevant section of the vehicle DC supply cable harness 22, and the voltage level (U), i.e. voltage drop, applied to said the section of the vehicle DC supply cable harness 22, and subsequently determining the resistance value based on equation $R = \frac{U}{I}$ .

This approach thus requires detection of both voltage and current levels. This may for example be performed by appropriate voltage and current sensors. For example, in figures 6 and 7, the voltage level of the relevant section of the vehicle DC supply cable harness 22 is derived from a voltage sensor (V) that measures supply voltage dedicated electrical power storage 18, and the current level of the relevant section of the vehicle DC supply cable harness 22 is measured by means of a current sensor (A).

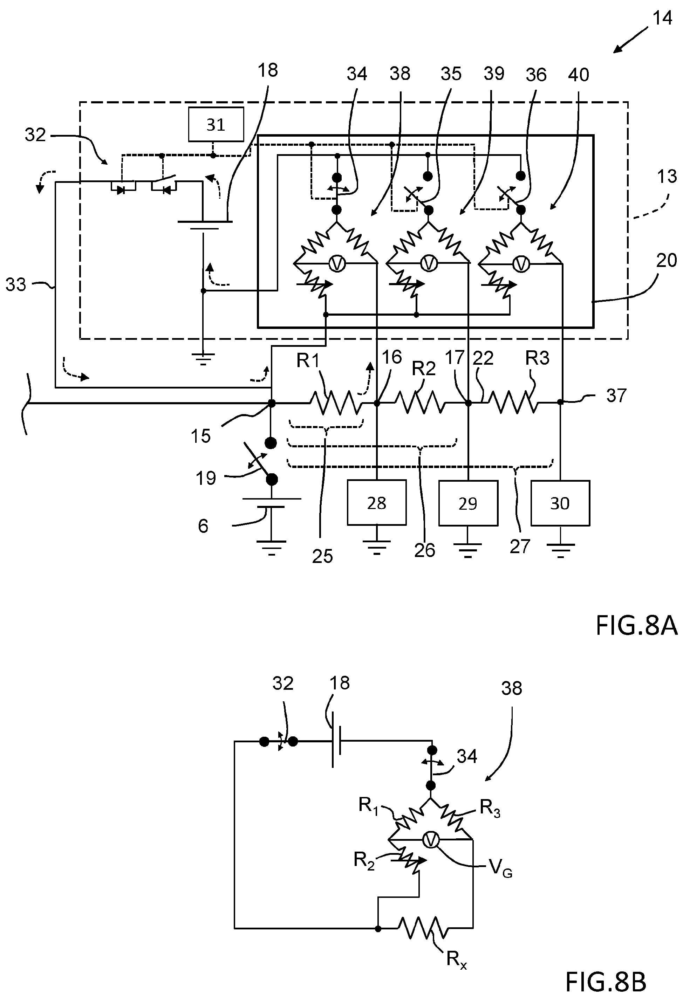

Alternatively, the resistance value of a certain section of the vehicle DC supply cable harness 22 may for example be determined using a Wheatstone bridge, as schematically illustrated in figure 8A.

Specifically, the resistance value may be determined based on registered voltage (V) between midpoints of the Wheatstone bridge that is connected to the relevant section of a vehicle DC supply cable harness 22 and the dedicated electrical power storage 18.

In the example embodiment of figure 8A, one individual Wheatstone bridge is connected to each of the first to third switches 34-36 of the switching arrangement 20. Hence, resistance value detection of the first section 25 is performed setting the first switch in closed state, while keeping the second and third switches remain in opened state, and registering voltage (V) between midpoints of the first Wheatstone bridge 38. Similarly, the resistance value detection of the second section 25 is performed setting the second switch in closed state, while keeping the first and third switches remain in opened state, and registering voltage (V) between midpoints of the second Wheatstone bridge 39, and so on.

Figure 8B schematically illustrates a simplified view of the resistance measurement circuit when the first switch 34 is closed. The first Wheatstone bridge includes four resistances $R_1$, $R_2$, $R_3$, $R_x$ connected in series in a circle, wherein $R_1$ and $R_3$ are known and fixed resistances, while $R_2$ is a variable resistance, and $R_x$ reflect the cable resistance of the first section 25 of a vehicle DC supply cable harness 22. The supple voltage (V) to the Wheatstone bridge corresponds to the voltage level of the dedicated electrical power storage 18, and the measured voltage ($V_G$) corresponds to the voltage level between midpoints of the Wheatstone bridge.

In such a scenario, the resistance value the first section 25 of a vehicle DC supply cable harness 22 may be determined by adjusting the resistance level of a variable resistance $R_2$ of the Wheatstone bridge, such that a measured voltage ($V_G$) between midpoints of the Wheatstone bridge is zero. At this point, the resistance value ($R_x$) of the first section 25 of a vehicle DC supply cable harness 22 may be derived by $R_x = \frac{R_3 R_2}{R_1}$ .

Alternatively, the resistance level of resistance $R_2$ of the Wheatstone bridge may be fixed and predetermined. In such a scenario, the resistance value the first section 25 of a vehicle DC supply cable harness 22 may be determined by detecting the voltage ($V_G$) between midpoints of the Wheatstone bridge, and simply calculating the resistance value ($R_x$) of the first section 25 of a vehicle DC supply cable harness 22 based on

$$V_G = V \times \left( \frac{R_1}{R_1 + R_2} + \frac{R_3}{R_3 + R_x} \right) \quad , \quad \text{or}$$

$$R_x = \frac{R_2 \times V - (R_1 + R_2) \times V_G}{R_1 \times V + (R_1 + R_2) \times V_G} \times R_3 \text{ , wherein V is the vol-}$$

tage level supplied to the Wheatstone bridge, $V_G$ is the measured voltage between midpoints of the Wheatstone bridge, and the resistance values of R1, R2, R3 are fixed and known.

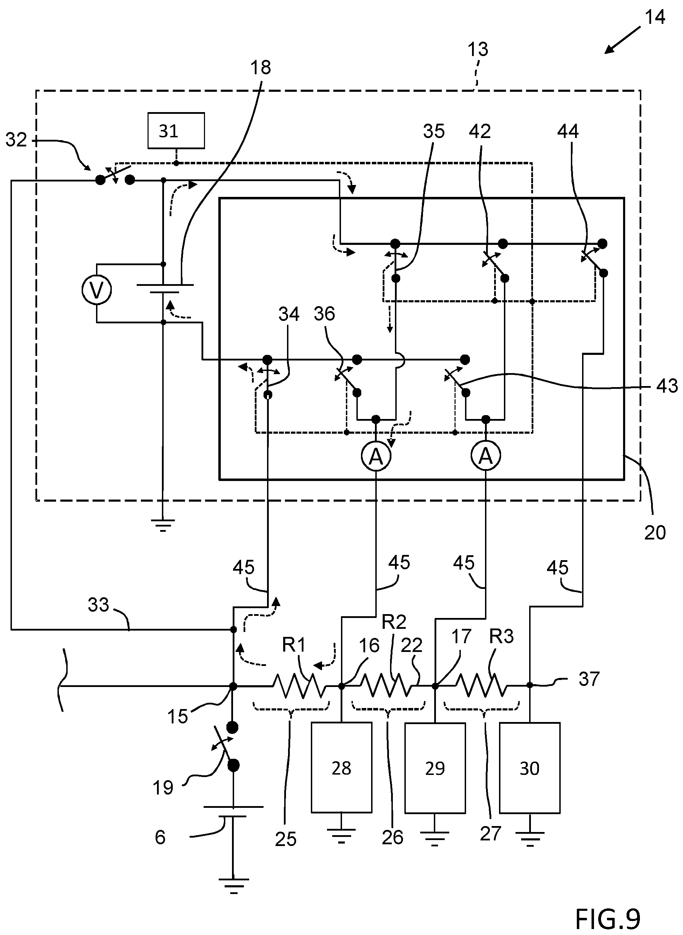

Figure 9 schematically shows an alternative embodiment of the switching arrangement 20, wherein neither the charging contactor 32 nor the electric charging line 33 is used for the cable resistance measurement of the relevant section of a vehicle DC supply cable harness 22. Instead, the switching arrangement 20 alone guides the power from the dedicated electrical power storage 18 to the relevant section of a vehicle DC supply cable harness 22. This is performed by providing the switching arrangement with more switches.

Specifically, a second switch 35 connects the positive pole of the dedicated electrical power storage 18 with the second node 16 of the vehicle DC supply cable harness 22, and a first switch 34 connects the negative pole of the dedicated electrical power storage 18 with the first node 15 of the vehicle DC supply cable harness 22. As result, setting both the first and second switches to closed state enables a current to flow through the first section 25 of the vehicle DC supply cable harness 22, wherein the first section 25 is defined by the first and second nodes 15, 16. This also requires that the electric charging line 33 is interrupted, for example by simply setting the charging contactor 32 in open state. This scenario is illustrated in figure 9.

Furthermore, a fourth switch 42 connects the positive pole of the dedicated electrical power storage 18 with the third node 17 of the vehicle DC supply cable harness 22, and a third switch 36 connects the negative pole of the dedicated electrical power storage 18 with the second node 16 of the vehicle DC supply cable harness 22. As result, setting both the third and fourth switches 36, 42 in closed state enables a current to flow through the second section 26 of the vehicle DC supply cable harness 22, wherein the second section 26 is defined by the second and third nodes 16, 17, and so on.

In other words, the cable resistance of the first section 25 of the vehicle DC supply cable harness 22, as defined by the first and second node points 15, 16, is schematically illustrated as a first resistor R1. The cable resistance of the second section 26 of the vehicle DC supply cable harness 22, as defined by the second and third node points 16, 17, is schematically illustrated as a second resistor R2. Similarly, the cable resistance of the third section 27 of the vehicle DC supply cable harness 22, as defined by the third and fourth node points 17, 37, is schematically illustrated as a the third resistor R3.

Resistance measurement of the first section 25 of the vehicle DC supply cable harness 22 may be performed by the following vehicle electrical system: the first switch 34 is connected to a first node point 15 of the vehicle DC supply cable harness, wherein the first node point 15 is located adjacent the low-voltage energy storage unit, and the second switch 35 is connected to the second node point 16 of the vehicle DC supply cable harness 22, wherein the second node point 16 is located adjacent the first low-voltage load 28, wherein the first and second node points 15, 16 define the first section 25 of the vehicle DC supply cable harness, wherein the electric control system is configured to generate the measurement current through the first section 25 of the vehicle DC supply cable harness by setting the charging contactor 32 in open state and setting the first and second switches 34, 35 in a closed state, such that a measurement current flows from the dedicated electrical power storage 18, through the second switch 35, the first section 25 of the vehicle DC supply cable harness, the first switch 34, and back to the dedicated electrical power storage 18.

Similarly, resistance measurement of the second section 26 of the vehicle DC supply cable harness 22 may performed by the following vehicle electrical system: the vehicle low-voltage electrical circuit 22 further has second low-voltage load 29 connected to the low-voltage energy storage unit 6 via the battery contactor 19 and a second section 26 of the vehicle DC supply cable harness, wherein the switching arrangement 20 is configured for selective connection of the dedicated electrical power storage 18 with the second section 26 of the vehicle DC supply cable harness, wherein the electric control system is configured to perform a resistance measurement of the second section 26 of the vehicle cable harness by: controlling the switching arrangement 20 for temporarily connecting the second section 26 of a vehicle DC supply cable harness with the dedicated electrical power storage 18 for generating a measurement current through the second section 26 of the vehicle DC supply cable harness 22, and determining a resistance value of the second section 26 of the vehicle DC supply cable harness based on the measurement current level through the second section 26.

In the example embodiment of figure 9, the resistance value of a certain section of the vehicle DC supply cable harness 22 may for example be determined using ohms law, as described above with reference to figures 6 and 7. This approach typically requires detection of both voltage and current levels.

Current measurement may be performed by one or more current sensors located anywhere along the current path from the dedicated electrical power storage 18 to the relevant section of the vehicle DC supply cable harness. Voltage measurement may be performed by measuring supply voltage level, as illustrated in figure 9. Alternatively, voltage measurement may be performed by individual voltage sensors detecting the voltage drop over each relevant section of the vehicle DC supply cable harness, separately. For example by including a plurality of voltage sensors in the switching arrangement 20.

When detecting the voltage drop over each relevant section of the vehicle DC supply cable harness, separately, by using voltage sensors located in the switching arrangement 20, the voltage drop caused by the internal resistance of the measurement conductors 45 themselves will typically induce a small measurement error. This may be overcome by measuring voltage drop over each relevant section of the vehicle DC supply cable harness by means of Kelvin method, which is also known as the 4-wire method.

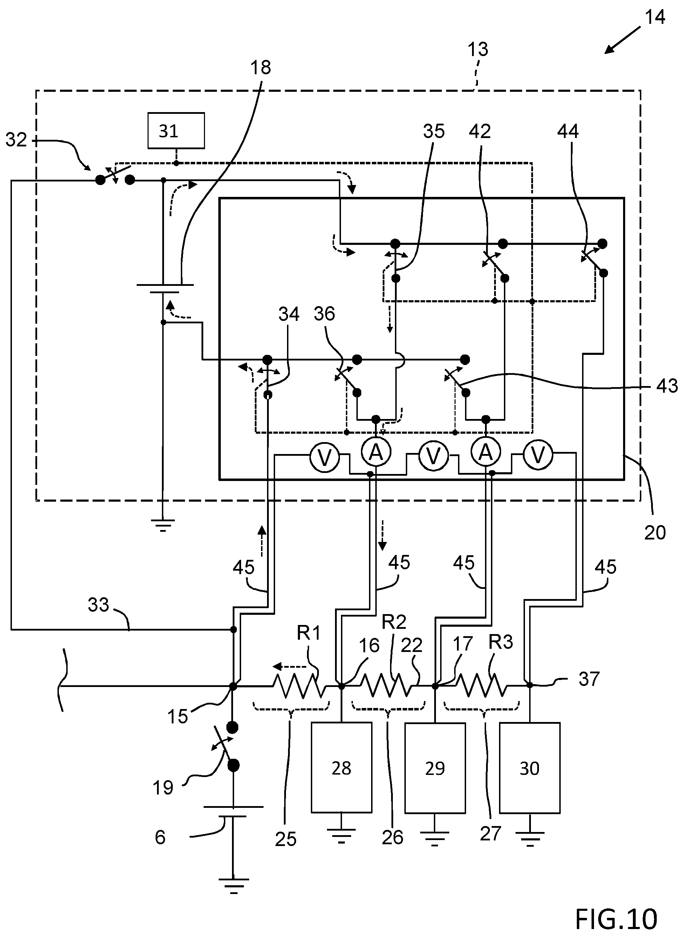

Specifically, for avoiding errors caused by wire resistance, the Kelvin, or 4-wire method, may be adopted. This is schematically illustrated in figure 10, which shows a plurality of individual voltage sensors, each configured to detect the voltage drop over an individual section of the vehicle DC supply cable harness. In figure 10, the plurality of individual voltage sensors are located in the switching arrangement 20, but they may be located somewhere also, distant from the vehicle DC supply cable harness. Each of the measurement conductors 45 may be configured as a dual-conductor wire, wherein one wire of the dual-wires connects the individual section of the vehicle DC supply cable harness with the dedicated electrical power storage 18, while the other wire of the dual-wires is connected to an individual voltage sensor. As a result, the current flowing through the measurement conductors 45 will be very low, such that the voltage drop caused by the internal resistance of the measurement conductors 45 themselves will become so small, compared with the resistance of the measured section of the vehicle DC supply cable harness, that it can be ignored, and the measurement accuracy is thereby improved.

The Kelvin method for detecting resistance of a remote electrical part as described with reference to figure 10 may be implemented in any other cables resistance measurement embodiment of the disclosure, specifically those described with reference to figures 4 - 8A, 9 and 11-15.

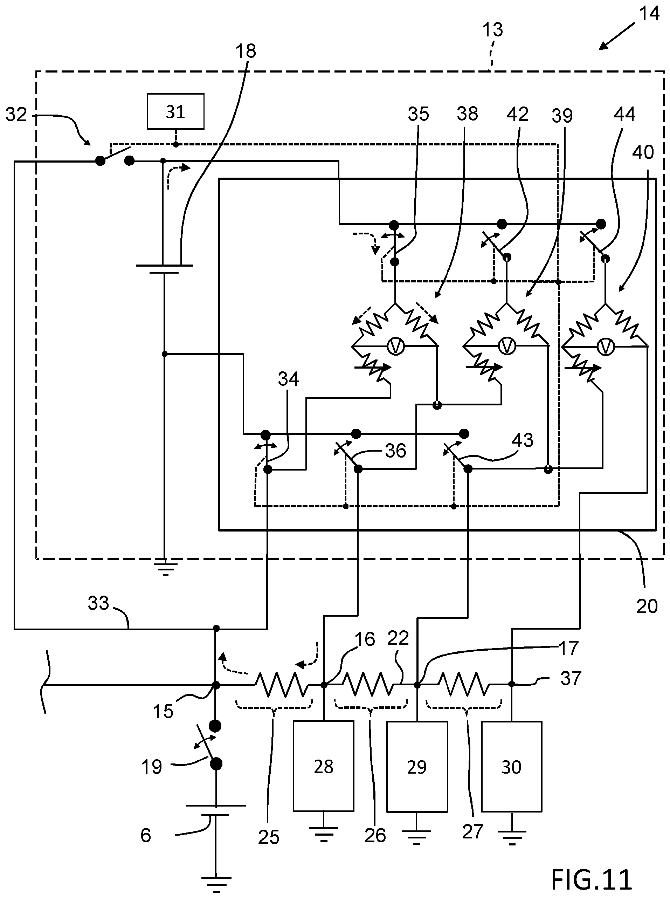

Still a further alternative approach for detecting the resistance value of a certain section of the vehicle DC supply cable harness 22 involves using a Wheatstone bridge, as schematically illustrated in figure 11. The electrical system of figure 9 to 11 have essentially the same functionality except in terms of how the resistance value of the relevant section of the vehicle DC supply cable harness 22 is determined. Reference is here made to figures 8A, 8B and the associated description for details of the functionality of the Wheatstone bridge.

Specifically, the resistance value of the first section 25 may be determined based on registered voltage ($V_g$) between midpoints of the first Wheatstone bridge 38 that is connected to the first section of a vehicle DC supply cable harness 22 and the dedicated electrical power storage 18.

The cable resistance measurement arrangement 13 has been disclosed as a separate part of the electrical system of figures 4 - 11, i.e. separate from vehicle low-voltage electrical circuit. However, the cable resistance measurement arrangement 13 may actually be integrated in a part of the existing vehicle low-voltage electrical circuit.

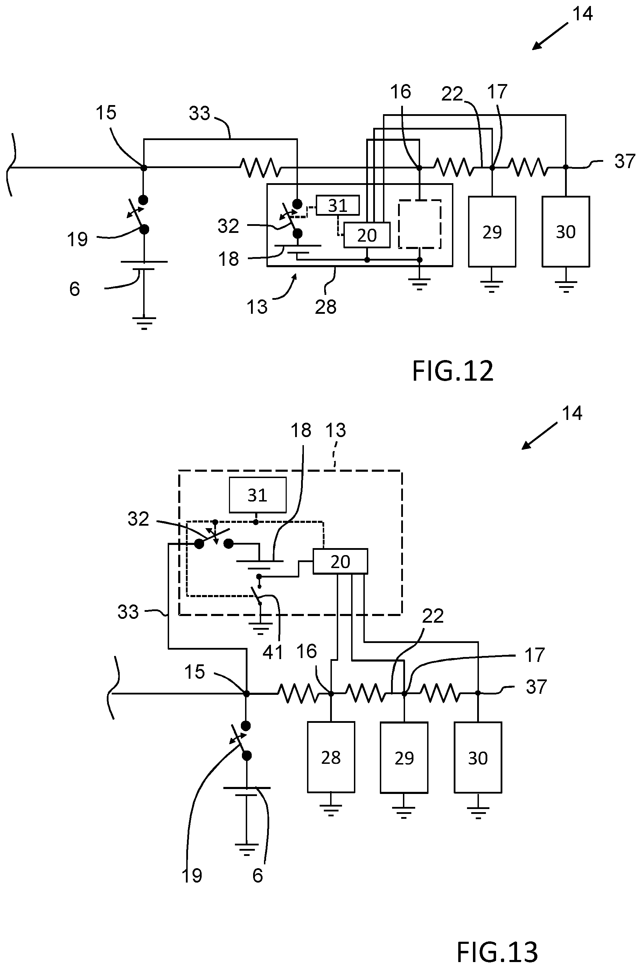

For example, as schematically illustrated in figure 12, the cable resistance measurement arrangement may for example be integrated in the first low-voltage load 28, such as for example an electrically actuated vehicle brake, or an electrically actuated vehicle steering.

Having the cable resistance measurement arrangement integrated in the first low-voltage load 28 enables a more compact design with less parts. In addition, the cable resistance measurement arrangement and first low-voltage load 28 may share an ECU, thereby reducing the number of components. In addition, the dedicated electrical power storage 18 may provide the first low-voltage load 28 with increased reliability, because the dedicated electrical power storage 18 may provide the first low-voltage load 28 with operational power also when the regular power supply for some reason have failed.

As schematically illustrated in figure 13, in some example embodiments of the vehicle electrical system, the negative pole of the dedicated electrical power storage 18 is connected to ground point via a ground contactor 41, wherein operation of the ground contactor 41 is controlled by the electronic measuring control unit 31, and wherein the electronic measuring control unit 31 is configured to set the ground contactor 41 in open state when a resistance measurement of a section of the vehicle DC supply cable harness is performed. Thereby, the risk for false measurement and/or false calculation of the resistance valve of the first section 25 is accomplished.

In some example embodiments, the electronic measuring control unit is configured to set the ground contactor in closed state during charging of the dedicated electrical power storage.

The cable resistance measurement arrangement 13 described with reference to figures 4 - 13 may be implemented in various vehicle electrical systems. One example implementation of the cable resistance measurement arrangement 13 in a vehicle electrical system is schematically showed in figure 14, which has a high-voltage electrical side for vehicle propulsion, and a low-voltage side having various safety critical low-voltage loads 28,29,30, such as for example electrical brake system, electrical steering, autonomous driving, or the like, connected to a low-voltage energy storage unit 6 via a low-voltage DC supply cable harness 22. For ensuring sufficient operation safety, the electrical system further has a redundant low-voltage circuit with redundant safety critical low-voltage loads 28*,29*,30* connected to a redundant low-voltage energy storage unit 6* via a redundant low-voltage DC supply cable harness 23.

Specially, figure 14 shows a vehicle electrical system further comprising: a high-voltage electrical storage system 5, and a DC/DC converter 9 connected to the high-voltage electrical storage system 5 and to the vehicle low-voltage electrical circuit and configured for supplying electrical power from the high-voltage electrical storage system 5 to the vehicle low-voltage electrical circuit. The vehicle electrical system further comprises an electrical vehicle propulsion motor 4 connected to the high-voltage electrical storage system 5 via a motor controller 8, such as for example an inverter in case of AC vehicle propulsion motor 4.

The vehicle electrical system according to figure 14 further comprises: a redundant vehicle low-voltage electrical circuit having a redundant low-voltage energy storage unit 6* connected to a redundant first low-voltage load 28* via a battery contactor 19* and a first section 25* of a redundant vehicle DC supply cable harness 23, an additional cable resistance measurement arrangement 13* having an additional dedicated electrical power storage 18* and an additional switching arrangement 20* configured for selective connection of the additional dedicated electrical power storage 18* with the first section 25* of the redundant vehicle DC supply cable harness 23.

Moreover, the vehicle electrical control system is configured for controlling operation of the switches of the additional switching arrangement 20* and the battery contactor 19* of the redundant low-voltage energy storage unit 6*, wherein the electric control system is configured to perform a resistance measurement of the first section 25* of the redundant vehicle DC supply cable harness 23 by: setting the battery contactor 19* of the redundant low-voltage energy storage unit 6* in open state for interrupting electrical power supply from the redundant low-voltage energy storage unit 6* to the redundant first low-voltage load 28*; controlling the additional switching arrangement 20* for temporarily connecting the first section 25* of the redundant vehicle DC supply cable harness 23 with the additional dedicated electrical power storage 18* for generating a measurement current through the first section 25* of the redundant vehicle DC supply cable harness 23; and determining a resistance value of the first section 25* of the redundant vehicle DC supply cable harness 23 based on the measurement current level.

The electric system 14 of figure 14 may additionally include and a redundant DC/DC converter 9* connected to the high-voltage electrical storage system 5 and to the redundant vehicle low-voltage electrical circuit and configured for supplying electrical power from the high-voltage electrical storage system 5 to the redundant vehicle low-voltage electrical circuit.

At least some of the low-voltage loads 28, 29, 30 of the vehicle low-voltage electrical circuit, which is powered by the low-voltage energy storage unit 6, may be controlled by a master electronic control unit (ECU) 10 that is connected to, and powered by, the low-voltage DC supply cable harness 22.

Similarly, at least some of the low-voltage loads 28*, 29*, 30* of the redundant vehicle low-voltage electrical circuit, which is powered by the redundant low-voltage energy storage unit 6*, may be controlled by a redundant master electronic control unit (ECU) 10* that is connected to, and powered by, the redundant low-voltage DC supply cable harness 23.

The master electronic control unit 10 may be arranged for controlling operation of the battery contactor 19, and/or the DC/DC converter 9, and the redundant master electronic control unit 10* may be arranged for controlling operation of the battery contactor 19* of the redundant vehicle low-voltage electrical circuit, and/or the redundant DC/DC converter 9*.

A further example implementation of the cable resistance measurement arrangement 13 in a vehicle electrical system is schematically showed in figure 15, which has a high-voltage electrical side for vehicle propulsion, and a low-voltage side having various safety critical low-voltage loads 28,29,30, such as for example electrical brake system, electrical steering, autonomous driving, or the like, connected to a low-voltage energy storage unit 6 via a low-voltage DC supply cable harness 22. For ensuring sufficient operation safety, the electrical system further has a redundant low-voltage circuit with redundant safety critical low-voltage loads 28*,29*,30* connected to a redundant low-voltage energy storage unit 6* via a redundant low-voltage DC supply cable harness 23.

However, the vehicle electrical system according to the embodiment of figure 15 differs from the earlier example implementation in that the vehicle electrical system merely include a single resistant measurement arrangement 13 that may be used for detecting resistance values of both the low-voltage DC supply cable harness 22 and the redundant low-voltage DC supply cable harness 23. In other words, the vehicle electrical system of figure 14 includes less parts.

Reference is made to figure 14, and associated description, for description of the vehicle electrical system of figure 15.

The electric control system of the embodiment of figure 15 is configured to perform a resistance measurement of a first section 25 of the redundant vehicle DC supply cable harness 23 by: setting the battery contactor 19* of the redundant low-voltage energy storage unit 6* in open state for interrupting electrical power supply from the redundant low-voltage energy storage unit 6* to the redundant first low-voltage load 28*; controlling the switching arrangement 20 of the single resistant measurement arrangement 13 for temporarily connecting the first section 25* of the redundant vehicle DC supply cable harness 23 with the dedicated electrical power storage 18 of the single resistant measurement arrangement 13 for generating a measurement current through the first section 25* of the redundant vehicle DC supply cable harness 23; and determining a resistance value of the first section 25* of the redundant vehicle DC supply cable harness 23 based on the measurement current level.

This resistance measurement process involves routing a measurement current from the positive pole of the dedicated electrical power storage 18 of the single resistant measurement arrangement 13 to the first section 25* of the redundant vehicle DC supply cable harness 23 via the first node 15 of the vehicle DC supply cable harness 22 and first node 15* of the redundant vehicle DC supply cable harness 23, and returning the measurement current from the second node point 16* of the redundant vehicle DC supply cable harness 23 to the negative pole of the dedicated electrical power storage 18 via the switching arrangement 20.

With respect to the example embodiments of figures 4-15, an additional benefit of the single resistant measurement arrangement 13 may be implemented by configuring the electric control system to use the dedicated electrical power storage 18 of the cable resistant measurement arrangement 13 as a redundant power supply for the vehicle low-voltage electrical circuit, in particular for powering any low-voltage load 28-30 connected to the vehicle DC supply cable harness 22, in case of failure or low charge level of the low-voltage energy storage unit 6, and/or for increasing supply voltage level of vehicle low-voltage electrical circuit.

As a result, the dedicated electrical power storage 18 of the cable resistant measurement arrangement 13 may thus be used to maintain the power consumption that is needed for certain time in case of failure of the normal power supply to the potentially safety critical low-voltage load(s) 28-30 of the vehicle low-voltage electrical circuit.

With reference to figure 16, the disclosure also relates to a method for determining a resistance value of the vehicle DC supply cable harness 22 of a vehicle electrical system, wherein the vehicle electrical system comprises: a vehicle low-voltage electrical circuit having a low-voltage energy storage unit connected to a first low-voltage load via a battery contactor and a first section of a vehicle DC supply cable harness; a cable resistance measurement arrangement having a dedicated electrical power storage and a switching arrangement configured for selective connection of the dedicated electrical power storage with the first section of a vehicle DC supply cable harness. The method comprises a first step S1 of setting the battery contactor in open state for interrupting electrical power supply from the low-voltage energy storage unit to the first low-voltage load. The method further comprises a second step S2 of controlling the switching arrangement for temporarily connecting the first section of a vehicle DC supply cable harness with the dedicated electrical power storage for generating a measurement current through the first section of the vehicle DC supply cable harness. Finally, the method comprises a third step S3 of determining a resistance value of the first section of the vehicle DC supply cable harness based on the measurement current level.

It will be appreciated that the above description is merely exemplary in nature and is not intended to limit the present disclosure, its application or uses. While specific examples have been described in the specification and illustrated in the drawings, it will be understood by those of ordinary skill in the art that various changes may be made without departing from the scope of the present disclosure as defined in the claims. Furthermore, modifications may be made to adapt a particular situation or material to the teachings of the present disclosure without departing from the essential scope thereof.

Therefore, it is intended that the present disclosure not be limited to the particular examples illustrated by the drawings and described in the specification as the best mode presently contemplated for carrying out the teachings of the present disclosure, but that the scope of the present disclosure will include any embodiments falling within the foregoing description and the appended claims. Reference signs mentioned in the claims should not be seen as limiting the extent of the matter protected by the claims, and their sole function is to make claims easier to understand.

REFERENCE SIGNS

1. Vehicle
2. Vehicle body
3. Wheels
4. Electric propulsion motor
5. High-voltage electrical storage system
6. Low-voltage energy storage unit
7. Redundant low-voltage energy storage unit
8. Motor controller
9. DC/DC converter
10. Master electronic control unit
11. On-board charging inlet
12. On-board charger
13. Cable resistance measurement arrangement
14. Vehicle electrical system
15. First node point
16. Second node point
17. Third node point
18. Dedicated electrical power storage
19. Battery contactor
20. Switching arrangement
21. Second electrical switch
22. Low-voltage DC supply cable harness (low-voltage DC bus)
23. Redundant low-voltage DC supply cable harness (redundant low-voltage DC bus)
24. High-voltage DC bus
25. First section of a vehicle DC supply cable harness
26. Second section of a vehicle DC supply cable harness
27. Third section of a vehicle DC supply cable harness
28. First low-voltage load
29. Second low-voltage load
30. Third low-voltage load
31. Dedicated electronic measuring control unit
32. Charging contactor
33. Charging line
34. First switch
35. Second switch
36. Third switch
37. Fourth node point
38. First Wheatstone bridge
39. Second Wheatstone bridge

40. Third Wheatstone bridge
41. Ground contactor
42. Fourth switch
43. Fifth switch
44. Sixth switch
45. Measurement conductor
9*. Redundant DC/DC converter
10*. Redundant Master electronic control unit
13*. Additional cable resistance measurement arrangement
15*. First node point
16*. Second node point
17*. Third node point
18*. Additional dedicated electrical power storage
19*. Battery contactor
20*. Additional switching arrangement
25* First section of redundant vehicle DC supply cable harness
28*. First redundant low-voltage load
29*. Second redundant low-voltage load
30*. Third redundant low-voltage load
31* Additional dedicated electronic measuring control unit
32*. Additional charging contactor

**Claims**

1. A vehicle electrical system comprising:

a vehicle low-voltage electrical circuit having a low-voltage energy storage unit (6) connected to a first low-voltage load (28) via a battery contactor (19) and a first section (25) of a vehicle DC supply cable harness (22),
a cable resistance measurement arrangement (13) having a dedicated electrical power storage (18) and a switching arrangement (20) configured for selective connection of the dedicated electrical power storage (18) with the first section (25) of a vehicle DC supply cable harness (22); and
an electrical control system configured for controlling operation of the switching arrangement (20) and the battery contactor (19);
wherein the electric control system is configured to perform a resistance measurement of the first section (25) of the vehicle DC supply cable harness (22) by:

setting the battery contactor (19) in open state for interrupting electrical power supply from the low-voltage energy storage unit (6) to the first low-voltage load (28);
controlling the switching arrangement (20) for temporarily connecting the first section (25) of a vehicle DC supply cable harness (22) with the dedicated electrical power storage (18) for generating a measurement current through the first section (25) of the vehicle DC supply cable harness (22); and determining a resistance value of the first section (25) of the vehicle DC supply cable harness (22) based on the measurement current level.

2. The vehicle electrical system according to claim 1,

   wherein the vehicle low-voltage electrical circuit further has second low-voltage load (29) connected to the low-voltage energy storage unit (6) via the battery contactor (19) and a second section (26) of the vehicle DC supply cable harness (22),
   wherein the switching arrangement (20) is configured for selective connection of the dedicated electrical power storage (18) with the second section (26) of the vehicle DC supply cable harness (22),
   wherein the electric control system is configured to perform a resistance measurement of the second section (26) of the vehicle cable harness (22) by:

   controlling the switching arrangement (20) for temporarily connecting the second section (26) of a vehicle DC supply cable harness (22) with the dedicated electrical power storage (18) for generating a measurement current through the second section (26) of the vehicle DC supply cable harness (22),
   determining a resistance value of the second section (26) of the vehicle DC supply cable harness (22) based on the measurement current level through the second section (26).

3. The vehicle electrical system according to any of the preceding claims, wherein the electric control system comprises a dedicated electronic measuring control unit (31) that is part of the cable resistance measurement arrangement (13), and wherein electronic measuring control unit (31) is configured for controlling operation of the switching arrangement (20), and for determining said resistance value of the vehicle DC supply cable harness (22).

4. The vehicle electrical system according to claim 3, wherein the electronic measuring control unit (31) is powered by the dedicated electrical power storage (18).

5. The vehicle electrical system according to any of the preceding claims, wherein the cable resistance measurement arrangement (13) further comprises a charging contactor (32) for selectively connecting the dedicated electrical power storage (18) with the low-voltage energy storage unit (6) for charging of the dedicated electrical power storage (18).

6. The vehicle electrical system according to any of the preceding claims, wherein the resistance value is determined:

   by registering the measurement current level (I) flowing through the relevant section of the vehicle DC supply cable harness (22), and the voltage level (U) applied to said the section of the vehicle DC supply cable harness (22), and determining the resistance value based on

   equation $R = \dfrac{U}{I}$, or

   based on registered voltage ($V_G$) between midpoints of a Wheatstone bridge (38-40) that is connected to the relevant section of a vehicle DC supply cable harness (22) and the dedicated electrical power storage (18).

7. The vehicle electrical system according to any of the preceding claims 5 to 6,

   wherein the charging contactor (32) is connected to a first node point (15) of the vehicle DC supply cable harness (22) located adjacent the low-voltage energy storage unit (6), wherein the switching arrangement (20) comprises a first switch (34) that is connected to a second node point (16) of the vehicle DC supply cable harness (22) located adjacent the first low-voltage load (28), wherein the first and second node points (15, 16) define the first section (25) of the vehicle DC supply cable harness (22), wherein the electric control system is configured to generate the measurement current through the first section (25) of the vehicle DC supply cable harness (22) by setting the charging contactor (32) and the first switch (34) in a closed state, such that a measurement current flows from the dedicated electrical power storage (18), through the charging contactor (32), the first section (25) of the vehicle DC supply cable harness, the first switch (34), and back to the dedicated electrical power storage (18), or
   wherein the switching arrangement (20) comprises a first switch (34) that is connected to a first node point (15) of the vehicle DC supply cable harness located adjacent the low-voltage energy storage unit (6), and a second switch (35) that is connected to a second node point (16) of the vehicle DC supply cable harness located adjacent the first low-voltage load (28), wherein the first and second node points (15, 16) define the first section (25) of the vehicle DC supply cable harness, wherein the electric control system is configured to generate the measurement current through the first section (25) of the vehicle DC supply cable harness by setting the charging contactor (32) in open state and setting the first and second switches (34, 35) in a closed state, such that a measurement current flows from the dedicated electrical power storage (18), through the second switch (35), the first section (25) of the vehicle DC supply cable harness, the first switch (34), and back to the dedicated electrical power storage (18).

8. The vehicle electrical system according to any of the preceding claims, wherein the electric control system is configured to use the dedicated electrical power storage (18) as a redundant power supply for the vehicle low-voltage electrical circuit, in particular for the first low-voltage load (28), in case of failure or low charge level of the low-voltage energy storage unit (6).

9. The vehicle electrical system according to any of the preceding claims, wherein the cable resistance measurement arrangement (13) is integrated in the first low-voltage load (28).

10. The vehicle electrical system according to any of the preceding claims, further comprising:

a high-voltage electrical storage system (5), a DC/DC converter (9) connected to the high-voltage electrical storage system (5) and to the vehicle low-voltage electrical circuit, and configured for supplying electrical power from the high-voltage electrical storage system (5) to the vehicle low-voltage electrical circuit, an electrical vehicle propulsion motor (4) connected to the high-voltage electrical storage system (5) via a motor controller (8).

11. The vehicle electrical system according to any of the preceding claims, further comprising:

a redundant vehicle low-voltage electrical circuit having a redundant low-voltage energy storage unit (6*) connected to a redundant first low-voltage load (28*) via a battery contactor (19*) and a first section (25*) of a redundant vehicle DC supply cable harness (23), wherein the switching arrangement (20) is configured for selective connection of the dedicated electrical power storage (18) with a first section (25*) of the redundant vehicle DC supply cable harness (23); and wherein the electric control system is configured to perform a resistance measurement of the first section (25*) of the redundant vehicle DC supply cable harness (23) by:

setting the battery contactor (19*) of the redundant low-voltage energy storage unit (6*) in open state for interrupting electrical power supply from the redundant low-voltage energy storage unit (6*) to the redundant first low-voltage load (28*); controlling the switching arrangement (20) for temporarily connecting the first section (25*) of a redundant vehicle DC supply cable harness with the dedicated electrical power storage (18) for generating a measurement current through the first section (25*) of the redundant vehicle DC supply cable harness (23); and determining a resistance value of the first section (25*) of the redundant vehicle DC supply cable harness based on the measurement current level.

12. A vehicle comprising the vehicle electrical system according to any of the preceding claims 1 - 11.

13. Method for determining a resistance value of the vehicle DC supply cable harness of a vehicle electrical system, wherein the vehicle electrical system comprises:

a vehicle low-voltage electrical circuit having a low-voltage energy storage unit (6) connected to a first low-voltage load (28) via a battery contactor (19) and a first section (25) of a vehicle DC supply cable harness (22), a cable resistance measurement arrangement (13) having a dedicated electrical power storage (18) and a switching arrangement (20) configured for selective connection of the dedicated electrical power storage (18) with the first section (25) of a vehicle DC supply cable harness (22); wherein the method comprises:

setting the battery contactor (19) in open state for interrupting electrical power supply from the low-voltage energy storage unit to the first low-voltage load; controlling the switching arrangement (20) for temporarily connecting the first section (25) of a vehicle DC supply cable harness with the dedicated electrical power storage (18) for generating a measurement current through the first section of the vehicle DC supply cable harness; and determining a resistance value of the first section (25) of the vehicle DC supply cable harness (22) based on the measurement current level.

14. The method according to claim 13,

wherein the vehicle low-voltage electrical circuit further has second low-voltage load (29) connected to the low-voltage energy storage unit (6) via the battery contactor (19) and a second section (26) of the vehicle DC supply cable harness (22),

wherein the switching arrangement (20) is configured for selective connection of the dedicated electrical power storage (18) with the second section of the vehicle DC supply cable harness, wherein the method comprises:

controlling the switching arrangement (20) for temporarily connecting the second section (26) of a vehicle DC supply cable harness with the dedicated electrical power storage (18) for generating a measurement current through the second section of the vehicle DC supply cable harness,

determining a resistance value of the second section (26) of the vehicle DC supply cable harness based on the measurement current level through the second section.

15. The method according to any of the preceding claims 13 to 14, wherein the vehicle electrical system further comprises:

a redundant vehicle low-voltage electrical circuit having a redundant low-voltage energy storage unit (6*) connected to a redundant first low-voltage load (28*) via a battery contactor (19*) and a first section (25*) of a redundant vehicle DC supply cable harness (23),

a DC/DC converter (9*) connected to the high-voltage electrical storage system (5) and to the redundant vehicle low-voltage electrical circuit, and configured for supplying electrical power from the high-voltage electrical storage system (5) to the redundant vehicle low-voltage electrical circuit,

wherein the switching arrangement (20) is configured for selective connection of the dedicated electrical power storage (18) with a first section (25*) of the redundant vehicle DC supply cable harness (23)

wherein the method comprises:

setting the battery contactor (19*) of the redundant low-voltage energy storage unit (6*) in open state for interrupting electrical power supply from the redundant low-voltage energy storage unit to the redundant first low-voltage load;

controlling the switching arrangement (20) for temporarily connecting the first section (25*) of the redundant vehicle DC supply cable harness (22) with the dedicated electrical power storage (18) for generating a measurement current through the first section of the redundant vehicle DC supply cable harness; and

determining a resistance value of the first section (25*) of the redundant vehicle DC supply cable harness (23) based on the measurement current level.

**Patentansprüche**

1. Elektrisches System für Fahrzeuge, umfassend:

einen Fahrzeug-Niedervolt-Stromkreis mit einer Niedervolt-Energiespeichereinheit (6), die über ein Batteriekontaktglied (19) und einen ersten Abschnitt (25) eines Fahrzeug-Gleichstrom-Versorgungskabelbaums (22) mit einer ersten Niedervolt-Last (28) verbunden ist,

eine Kabelwiderstandsmessanordnung (13) mit einem dedizierten elektrischen Energiespeicher (18) und einer Schaltanordnung (20), die zur selektiven Verbindung des dedizierten elektrischen Energiespeichers (18) mit dem ersten Abschnitt (25) eines Fahrzeug-Gleichstrom-Versorgungskabelbaums (22) ausgelegt ist; und

ein elektrisches Steuersystem, das zur Steuerung des Betriebs der Schaltanordnung (20) und des Batteriekontaktglieds (19) ausgelegt ist;

wobei das elektrische Steuersystem dazu ausgelegt ist, eine Widerstandsmessung des ersten Abschnitts (25) des Fahrzeug-Gleichstrom-Versorgungskabelbaums (22) durchzuführen, indem:

das Batteriekontaktglied (19) in einen offenen Zustand versetzt wird, um die elektrische Energieversorgung von der Niedervolt-Energiespeichereinheit (6) zur ersten Niedervolt-Last (28) zu unterbrechen;

die Schaltanordnung (20) so gesteuert wird, dass der erste Abschnitt (25) eines Fahrzeug-Gleichstrom-Versorgungskabelbaums (22) vorübergehend mit dem dedizierten elektrischen Energiespeicher (18) verbunden wird, um einen Messstrom durch den ersten Abschnitt (25) des Fahrzeug-Gleichstrom-Versorgungskabelbaums (22) zu erzeugen; und

ein Widerstandswert des ersten Abschnitts (25) des Fahrzeug-Gleichstrom-Versorgungskabelbaums (22) basierend auf dem Messstrompegel bestimmt wird.

2. Elektrisches System für Fahrzeuge nach Anspruch 1,

wobei der Fahrzeug-Niedervolt-Stromkreis ferner eine zweite Niedervolt-Last (29) aufweist, die über das Batteriekontaktglied (19) und einen zweiten Abschnitt (26) des Fahrzeug-Gleichstrom-Versorgungskabelbaums (22) mit der Niedervolt-Energiespeichereinheit (6) verbunden ist,

wobei die Schaltanordnung (20) zur selektiven Verbindung des dedizierten elektrischen Energiespeichers (18) mit dem zweiten Abschnitt (26) des Fahrzeug-Gleichstrom-Versorgungskabelbaums (22) ausgelegt ist,

wobei das elektrische Steuersystem dazu ausgelegt ist, eine Widerstandsmessung des zweiten Abschnitts (26) des Fahrzeug-Kabelbaums (22) durchzuführen, indem:

die Schaltanordnung (20) so gesteuert wird, dass der zweite Abschnitt (26) eines Fahrzeug-Gleichstrom-Versorgungskabelbaums (22) vorübergehend mit dem dedizierten elektrischen Energiespeicher (18) verbunden wird, um einen Messstrom durch den zweiten Abschnitt (26) des Fahrzeug-Gleichstrom-Versorgungskabelbaums (22) zu erzeugen,

ein Widerstandswert des zweiten Abschnitts (26) des Fahrzeug-Gleichstrom-Versorgungskabelbaums (22) basierend auf dem Messstrompegel durch den zweiten Abschnitt (26) bestimmt wird.

3. Elektrisches System für Fahrzeuge nach einem der vorstehenden Ansprüche, wobei das elektrische Steuersystem eine dedizierte elektronische Messsteuereinheit (31) umfasst, die Teil der Kabelwiderstandsmessanordnung (13) ist, und wobei die elektronische Messsteuereinheit (31) dazu ausgelegt ist, den Betrieb der Schaltanordnung (20) zu steuern und den Widerstandswert des Fahrzeug-Gleichstrom-Versorgungskabelbaums (22) zu bestimmen.

4. Elektrisches System für Fahrzeuge nach Anspruch 3, wobei die elektronische Messsteuereinheit (31) durch den dedizierten elektrischen Energiespeicher (18) mit Energie versorgt wird.

5. Elektrisches System für Fahrzeuge nach einem der vorstehenden Ansprüche, wobei die Kabelwiderstandsmessanordnung (13) ferner ein Ladekontaktglied (32) umfasst, das zur selektiven Verbindung des dedizierten elektrischen Energiespeichers (18) mit der Niedervolt-Energiespeichereinheit (6) zum Laden des dedizierten elektrischen Energiespeichers (18) vorgesehen ist.

6. Elektrisches System für Fahrzeuge nach einem der vorstehenden Ansprüche, wobei der Widerstandswert bestimmt wird:

durch Erfassen des Messstrompegels (I), der durch den betreffenden Abschnitt des Fahrzeug-Gleichstrom-Versorgungskabelbaums (22) fließt, und des Spannungspegels (U), der an den Abschnitt des Fahrzeug-Gleichstrom-Versorgungskabelbaums (22) angelegt ist, und Bestimmung des Widerstandswerts basierend auf einer Gleichung $R = \frac{U}{I}$, oder

basierend auf einer erfassten Spannung ($V_G$) zwischen Mittelpunkten einer Wheatstone-Brücke (38-40), die mit dem betreffenden Abschnitt des Fahrzeug-Gleichstrom-Versorgungskabelbaums (22) und dem dedizierten elektrischen Energiespeicher (18) verbunden ist.

7. Elektrisches System für Fahrzeuge nach einem der vorstehenden Ansprüche 5 bis 6,

wobei das Ladekontaktglied (32) mit einem ersten Knotenpunkt (15) des Fahrzeug-Gleichstrom-Versorgungskabelbaums (22) verbunden ist, der benachbart zu der Niedervolt-Energiespeichereinheit (6) angeordnet ist, wobei die Schaltanordnung (20) einen ersten Schalter (34) umfasst, der mit einem zweiten Knotenpunkt (16) des Fahrzeug-Gleichstrom-Versorgungskabelbaums (22) verbunden ist, der benachbart zur ersten Niedervolt-Last (28) angeordnet ist, wobei der erste und der zweite Knotenpunkt (15, 16) den ersten Abschnitt (25) des Fahrzeug-Gleichstrom-Versorgungskabelbaums (22) definieren, wobei das elektrische Steuersystem dazu ausgelegt ist, den Messstrom durch den ersten Abschnitt (25) des Fahrzeug-Gleichstrom-Versorgungskabelbaums (22) zu erzeugen, indem das Ladekontaktglied (32) und der erste Schalter (34) in einen geschlossenen Zustand versetzt werden, sodass ein Messstrom vom dedizierten elektrischen Energiespeicher (18) über das Ladekontaktglied (32), den ersten Abschnitt (25) des Fahrzeug-Gleichstrom-Versorgungskabelbaums, den ersten Schalter (34) und zurück zum dedizierten elektrischen Energiespeicher (18) fließt, oder

wobei die Schaltanordnung (20) einen ersten Schalter (34) umfasst, der mit einem ersten Knotenpunkt (15) des Fahrzeug-Gleichstrom-Versorgungskabelbaums verbunden ist, der benachbart zu der Niedervolt-Energiespeichereinheit (6) angeordnet ist, und einen zweiten Schalter (35), der mit einem zweiten Knotenpunkt (16) des Fahrzeug-Gleichstrom-Versorgungskabelbaums verbunden ist, der benachbart zur ersten Niedervolt-Last (28) angeordnet ist, wobei der erste und der zweite Knotenpunkt (15, 16) den ersten Abschnitt (25) des Fahrzeug-Gleichstrom-Versorgungskabelbaums definieren, wobei das elektrische Steuersystem dazu ausgelegt ist, den Messstrom durch den ersten Abschnitt (25) des Fahrzeug-Gleichstrom-Versorgungskabelbaums zu erzeugen, indem das Ladekontaktglied (32) in einen offenen Zustand versetzt wird und der erste und der zweite Schalter (34, 35) in einen geschlossenen Zustand versetzt werden, sodass ein Messstrom vom dedizierten elektrischen Energiespeicher (18) über den zweiten Schalter (35), den ersten Abschnitt (25) des Fahrzeug-Gleichstrom-Versorgungskabelbaums, den ersten Schalter (34) und zurück zum dedizierten elektrischen Energiespeicher (18) fließt.

8. Elektrisches System für Fahrzeuge nach einem der vorstehenden Ansprüche, wobei das elektrische Steuersystem dazu ausgelegt ist, den dedizierten elektrischen Energiespeicher (18) als redundante Energieversorgung für den Fahrzeug-Niedervolt-Stromkreis zu verwenden, insbesondere für die erste Niedervolt-Last (28), im Falle eines Ausfalls oder eines niedrigen Ladezustands der Niedervolt-Energiespeichereinheit (6).

9. Elektrisches System für Fahrzeuge nach einem der vorstehenden Ansprüche, wobei die Kabelwiderstandsmessanordnung (13) in die erste Niedervolt-Last (28) integriert ist.

10. Elektrisches System für Fahrzeuge nach einem der vorstehenden Ansprüche, ferner umfassend:

ein elektrisches Hochvolt-Speichersystem (5), einen Gleichstrom/Gleichstrom-Wandler (9), der mit dem elektrischen Hochvolt-Speichersystem (5) und dem Fahrzeug-Niedervolt-Stromkreis verbunden und dazu ausgelegt ist, elektrische Energie vom elektrischen Hochvolt-Speichersystem (5) zum Fahrzeug-Niedervolt-Stromkreis bereitzustellen, einen elektrischen Fahrzeugantriebsmotor (4), der über einen Motorregler (8) mit dem elektrischen Hochvolt-Speichersystem (5) verbunden ist.

11. Elektrisches System für Fahrzeuge nach einem der vorstehenden Ansprüche, ferner umfassend:

einen redundanten Fahrzeug-Niedervolt-Stromkreis mit einer redundanten Niedervolt-Energiespeichereinheit (6*), die über ein Batteriekontaktglied (19*) und einen ersten Abschnitt (25*) eines redundanten Fahrzeug-Gleichstrom-Versorgungskabelbaums (23) mit einer redundanten ersten Niedervolt-Last (28*) verbunden ist, wobei die Schaltanordnung (20) zur selektiven Verbindung des dedizierten elektrischen Energiespeichers (18) mit einem ersten Abschnitt (25*) des redundanten Fahrzeug-Gleichstrom-Versorgungskabelbaums (23) ausgelegt ist; und wobei das elektrische Steuersystem dazu ausgelegt ist, eine Widerstandsmessung des ersten Abschnitts (25*) des redundanten Fahrzeug-Gleichstrom-Versorgungskabelbaums (23) durchzuführen, indem:

das Batteriekontaktglied (19*) der redundanten Niedervolt-Energiespeichereinheit (6*) in einen offenen Zustand versetzt wird, um die elektrische Energieversorgung von der redundanten Niedervolt-Energiespeichereinheit (6*) zur redundanten ersten Niedervolt-Last (28*) zu unterbrechen; die Schaltanordnung (20) so gesteuert wird, dass der erste Abschnitt (25*) eines redundanten Fahrzeug-Gleichstrom-Versorgungskabelbaums vorübergehend mit dem dedizierten elektrischen Energiespeicher (18) verbunden wird, um einen Messstrom durch den ersten Abschnitt (25*) des redundanten Fahrzeug-Gleichstrom-Versorgungskabelbaums (23) zu erzeugen; und ein Widerstandswert des ersten Abschnitts (25*) des redundanten Fahrzeug-Gleichstrom-Versorgungskabelbaums basierend auf dem Messstrompegel bestimmt wird.

12. Fahrzeug, das das elektrische System für Fahrzeuge nach einem der vorstehenden Ansprüche 1 bis 11 umfasst.

13. Verfahren zum Bestimmen eines Widerstandswerts des Fahrzeug-Gleichstrom-Versorgungskabelbaums eines elektrischen Systems für Fahrzeuge, wobei das elektrische System für Fahrzeuge umfasst:

einen Fahrzeug-Niedervolt-Stromkreis mit einer Niedervolt-Energiespeichereinheit (6), die über ein Batteriekontaktglied (19) und einen ersten Abschnitt (25) eines Fahrzeug-Gleichstrom-Versorgungskabelbaums (22) mit einer ersten Niedervolt-Last (28) verbunden ist, eine Kabelwiderstandsmessanordnung (13) mit einem dedizierten elektrischen Energiespeicher (18) und einer Schaltanordnung (20), die zur selektiven Verbindung des dedizierten elektrischen Energiespeichers (18) mit dem ersten Abschnitt (25) eines Fahrzeug-Gleichstrom-Versorgungskabelbaums (22) ausgelegt ist; wobei das Verfahren umfasst:

Versetzen des Batteriekontaktglieds (19) in einen offenen Zustand, um die elektrische Energieversorgung von der Niedervolt-Energiespeichereinheit zur ersten Niedervolt-Last zu unterbrechen; Steuern der Schaltanordnung (20) derart, dass der erste Abschnitt (25) eines Fahrzeug-Gleichstrom-Versorgungskabelbaums vorübergehend mit dem dedizierten elektrischen Energiespeicher (18) verbunden wird, um einen Messstrom durch den ersten Abschnitt des Fahrzeug-Gleichstrom-Versorgungskabelbaums zu erzeugen; und Bestimmen eines Widerstandswerts des ersten Abschnitts (25) des Fahrzeug-Gleichstrom-Versorgungskabelbaums (22) basierend auf dem Messstrompegel.

14. Verfahren nach Anspruch 13,

wobei der Fahrzeug-Niedervolt-Stromkreis ferner eine zweite Niedervolt-Last (29) aufweist, die über das Batteriekontaktglied (19) und einen zweiten Abschnitt (26) des Fahrzeug-Gleichstrom-Versorgungskabelbaums (22) mit der Niedervolt-Energiespeichereinheit (6) verbunden ist, wobei die Schaltanordnung (20) zur selektiven Verbindung des dedizierten elektrischen Energiespeichers (18) mit dem zweiten Abschnitt des Fahrzeug-Gleichstrom-Versorgungskabelbaums ausgelegt ist, wobei das Verfahren umfasst:

Steuern der Schaltanordnung (20) derart, dass der zweite Abschnitt (26) eines Fahrzeug-Gleichstrom-Versorgungskabelbaums vorübergehend mit dem dedizierten elektrischen Energiespeicher (18) verbunden wird, um einen Messstrom durch den zweiten Abschnitt des Fahrzeug-Gleichstrom-Versorgungskabelbaums zu erzeugen, Bestimmen eines Widerstandswerts des zweiten Abschnitts (26) des Fahrzeug-Gleichstrom-Versorgungskabelbaums basierend auf dem Messstrompegel durch den zweiten Abschnitt.

15. Verfahren nach einem der vorstehenden Ansprüche 13 bis 14, wobei das elektrische System für Fahrzeuge ferner umfasst:

einen redundanten Fahrzeug-Niedervolt-Stromkreis mit einer redundanten Niedervolt-Energiespeichereinheit (6*), die über ein Batteriekontaktglied (19*) und einen ersten Abschnitt (25*) eines redundanten Fahrzeug-Gleichstrom-Versorgungskabelbaums (23) mit einer redundanten ersten Niedervolt-Last (28*) verbunden ist, einen Gleichstrom/Gleichstrom-Wandler (9*), der mit dem elektrischen Hochvolt-Speichersystem (5) und dem redundanten Fahrzeug-Niedervolt-Stromkreis verbunden und dazu ausgelegt ist, elektrische Energie vom elektrischen Hochvolt-Speichersystem (5) zum redundanten Fahrzeug-Niedervolt-Stromkreis bereitzustellen, wobei die Schaltanordnung (20) zur selektiven Verbindung des dedizierten elektrischen Energiespeichers (18) mit einem ersten Abschnitt (25*) des redundanten Fahrzeug-Gleichstrom-Versorgungskabelbaums (23) ausgelegt ist, wobei das Verfahren umfasst:

Versetzen des Batteriekontaktglieds (19*) der redundanten Niedervolt-Energiespeichereinheit (6*) in einen offenen Zustand, um die elektrische Energieversorgung von der redundanten Niedervolt-Energiespeichereinheit zur redundanten ersten Niedervolt-Last zu unterbrechen; Steuern der Schaltanordnung (20), um den ersten Abschnitt (25*) des redundanten Fahrzeug-Gleichstrom-Versorgungskabelbaums (22) vorübergehend mit dem dedizierten elektrischen Energiespeicher (18) zu verbinden, um einen Messstrom durch den ersten Abschnitt des redundanten Fahrzeug-Gleichstrom-Versorgungskabelbaums zu erzeugen; und Bestimmen eines Widerstandswerts des ersten Abschnitts (25*) des redundanten Fahrzeug-Gleichstrom-Versorgungskabelbaums (23) basierend auf dem Messstrompegel.

**Revendications**

1. Système électrique de véhicule comprenant :

un circuit électrique basse tension de véhicule ayant une unité de stockage d'énergie basse tension (6) connectée à une première charge basse tension (28) via un contacteur de batterie (19) et une première section (25) d'un faisceau de câbles d'alimentation CC de véhicule (22), un agencement de mesure de résistance de câble (13) ayant un stockage d'énergie électrique dédié (18) et un agencement de commutation (20) configuré pour une connexion sélective du stockage d'énergie électrique dédié (18) avec la première section (25) d'un faisceau de câbles d'alimentation CC de véhicule (22) ; et un système de commande électrique configuré pour commander le fonctionnement de l'agencement de commutation (20) et du contacteur de batterie (19) ;

dans lequel le système de commande électrique est configuré pour réaliser une mesure de résistance de la première section (25) du faisceau de câbles d'alimentation CC de véhicule (22) par :

le réglage du contacteur de batterie (19) en état ouvert pour interrompre l'alimentation électrique provenant de l'unité de stockage d'énergie basse tension (6) vers la première charge basse tension (28) ;

la commande de l'agencement de commutation (20) pour connecter temporairement la première section (25) d'un faisceau de câbles d'alimentation CC de véhicule (22) avec le stockage d'énergie électrique dédié (18) pour générer un courant de mesure à travers la première section (25) du faisceau de câbles d'alimentation CC de véhicule (22) ; et

la détermination d'une valeur de résistance de la première section (25) du faisceau de câbles d'alimentation CC de véhicule (22) sur la base du niveau de courant de mesure.

2. Système électrique de véhicule selon la revendication 1,

dans lequel le circuit électrique basse tension de véhicule a en outre une seconde charge basse tension (29) connectée à l'unité de stockage d'énergie basse tension (6) via le contacteur de batterie (19) et une seconde section (26) du faisceau de câbles d'alimentation CC de véhicule (22),

dans lequel l'agencement de commutation (20) est configuré pour une connexion sélective du stockage d'énergie électrique dédié (18) avec la seconde section (26) du faisceau de câbles d'alimentation CC de véhicule (22),

dans lequel le système de commande électrique est configuré pour réaliser une mesure de résistance de la seconde section (26) du faisceau de câbles de véhicule (22) par :

la commande de l'agencement de commutation (20) pour connecter temporairement la seconde section (26) d'un faisceau de câbles d'alimentation CC de véhicule (22) avec le stockage d'énergie électrique dédié (18) pour générer un courant de mesure à travers la seconde section (26) du faisceau de câbles d'alimentation CC de véhicule (22),

la détermination d'une valeur de résistance de la seconde section (26) du faisceau de câbles d'alimentation CC de véhicule (22) sur la base du niveau de courant de mesure à travers la seconde section (26).

3. Système électrique de véhicule selon l'une quelconque des revendications précédentes, dans lequel le système de commande électrique comprend une unité de commande de mesure électronique dédiée (31) qui fait partie de l'agencement de mesure de résistance de câble (13), et dans lequel l'unité de commande de mesure électronique (31) est configurée pour commander le fonctionnement de l'agencement de commutation (20), et pour déterminer ladite valeur de résistance du faisceau de câbles d'alimentation CC de véhicule (22).

4. Système électrique de véhicule selon la revendication 3, dans lequel l'unité de commande de mesure électronique (31) est alimentée par le stockage d'énergie électrique dédié (18).

5. Système électrique de véhicule selon l'une quelconque des revendications précédentes, dans lequel l'agencement de mesure de résistance de câble (13) comprend en outre un contacteur de charge (32) pour connecter sélectivement le stockage d'énergie électrique dédié (18) avec l'unité de stockage d'énergie basse tension (6) pour la charge du stockage d'énergie électrique dédié (18).

6. Système électrique de véhicule selon l'une quelconque des revendications précédentes, dans lequel la valeur de résistance est déterminée :

en enregistrant le niveau de courant de mesure (I) circulant à travers la section concernée du faisceau de câbles d'alimentation CC de véhicule (22), et le niveau de tension (U) appliqué à ladite section du faisceau de câbles d'alimentation CC de véhicule (22), et en déterminant la valeur de résistance sur la base de l'équation

$$R = \frac{U}{I},$$ ou

sur la base d'une tension enregistrée ($V_G$) entre des points milieux d'un pont de Wheatstone (38-40) qui est connecté à la section concernée d'un faisceau de câbles d'alimentation CC de véhicule (22) et au stockage d'énergie électrique dédié (18).

7. Système électrique de véhicule selon l'une quelconque des revendications précédentes 5 à 6,

dans lequel le contacteur de charge (32) est connecté à un premier point nodal (15) du faisceau de câbles d'alimentation CC de véhicule (22) situé de manière adjacente à l'unité de stockage d'énergie basse tension (6), dans lequel l'agencement de commutation (20) comprend un premier commutateur (34) qui est connecté à un second point nodal (16) du faisceau de câbles d'alimentation CC de véhicule (22) situé de manière adjacente à la première charge basse tension (28), dans lequel les premier et second points nodaux (15, 16) définissent la première section (25) du faisceau de câbles d'alimentation CC de véhicule (22), dans lequel le système de commande électrique est configuré pour générer le courant de mesure à travers la première section (25) du faisceau de câbles d'alimentation CC de véhicule (22) en réglant le contacteur de charge (32) et le premier commutateur (34) dans un état fermé, de telle sorte qu'un courant de mesure circule à partir du stockage d'énergie électrique dédié (18), à travers le contacteur de charge (32), la première section (25) du faisceau de câbles d'alimentation CC de véhicule, le premier commutateur (34), et retourne vers le stockage d'énergie électrique dédié (18), ou

dans lequel l'agencement de commutation (20) comprend un premier commutateur (34) qui est connecté à un premier point nodal (15) du faisceau de câbles d'alimentation CC de véhicule situé de manière adjacente à l'unité de stockage d'énergie basse tension (6), et un second commutateur (35) qui est connecté à un second point nodal (16) du faisceau de câbles d'alimentation CC de véhicule situé de manière adjacente à la première charge basse tension (28), dans lequel les premier et second points nodaux (15, 16) définissent la première section (25) du faisceau de câbles d'alimentation CC de véhicule, dans lequel le système de commande électrique est configuré pour générer le courant de mesure à travers la première section (25) du faisceau de câbles d'alimentation CC de véhicule en réglant le contacteur de charge (32) en état ouvert et en réglant les premier et second commutateurs (34, 35) dans un état fermé, de telle sorte qu'un courant de mesure circule à partir du stockage d'énergie électrique dédié (18), à travers le second commutateur (35), la première section (25) du faisceau de câbles d'alimentation CC de véhicule, le premier commutateur (34), et retourne vers le stockage d'énergie électrique dédié (18).

8. Système électrique de véhicule selon l'une quelconque des revendications précédentes, dans lequel le système de commande électrique est configuré pour utiliser le stockage d'énergie électrique dédié (18) en tant qu'alimentation électrique redondante pour le circuit électrique basse tension de véhicule, en particulier pour la première charge basse tension (28), en cas de défaillance ou de faible niveau de charge de l'unité de stockage d'énergie basse tension (6).

9. Système électrique de véhicule selon l'une quelconque des revendications précédentes, dans lequel l'agencement de mesure de résistance de câble (13) est intégré dans la première charge basse tension (28).

10. Système électrique de véhicule selon l'une quelconque des revendications précédentes, comprenant en outre :

un système de stockage électrique haute tension (5),
un convertisseur CC/CC (9) connecté au système de stockage électrique haute tension (5) et au circuit électrique basse tension de véhicule, et configuré pour fournir de l'énergie électrique provenant du système de stockage électrique haute tension (5) au circuit électrique basse tension de véhicule,
un moteur de propulsion de véhicule électrique (4) connecté au système de stockage électrique haute tension (5) via un contrôleur de moteur (8).

11. Système électrique de véhicule selon l'une quelconque des revendications précédentes, comprenant en outre :

un circuit électrique basse tension de véhicule redondant ayant une unité de stockage d'énergie basse tension redondante (6*) connectée à une première charge basse tension redondante (28*) via un contacteur de batterie (19*) et une première section (25*) d'un faisceau de câbles d'alimentation CC de véhicule redondant (23), dans lequel l'agencement de commutation (20) est configuré pour une connexion sélective du stockage d'énergie électrique dédié (18) avec une première section (25*) du faisceau de câbles d'alimentation CC de véhicule redondant (23) ; et
dans lequel le système de commande électrique est configuré pour réaliser une mesure de résistance de la première section (25*) du faisceau de câbles d'alimentation CC de véhicule redondant (23) par :

le réglage du contacteur de batterie (19*) de l'unité de stockage d'énergie basse tension redondante (6*) en état ouvert pour interrompre l'alimentation électrique provenant de l'unité de stockage d'énergie basse tension redondante (6*) vers la première charge basse tension redondante (28*) ; la commande de l'agencement de commutation (20) pour connecter temporairement la première section (25*) d'un faisceau de câbles d'alimentation CC de véhicule redondant avec le stockage d'énergie électrique dédié (18) pour générer un courant de mesure à travers la première section (25*) du faisceau de câbles d'alimentation CC de véhicule redondant (23) ; et la détermination d'une valeur de résistance de la première section (25*) du faisceau de câbles d'alimentation CC de véhicule redondant sur la base du niveau de courant de mesure.

12. Véhicule comprenant le système électrique de véhicule selon l'une quelconque des revendications précédentes 1 à 11.

13. Procédé de détermination d'une valeur de résistance du faisceau de câbles d'alimentation CC de véhicule d'un système électrique de véhicule, dans lequel le système électrique de véhicule comprend :

un circuit électrique basse tension de véhicule ayant une unité de stockage d'énergie basse tension (6) connectée à une première charge basse tension (28) via un contacteur de batterie (19) et une première section (25) d'un faisceau de câbles d'alimentation CC de véhicule (22), un agencement de mesure de résistance de câble (13) ayant un stockage d'énergie électrique dédié (18) et un agencement de commutation (20) configuré pour une connexion sélective du stockage d'énergie électrique dédié (18) avec la première section (25) d'un faisceau de câbles d'alimentation CC de véhicule (22) ; dans lequel le procédé comprend :

le réglage du contacteur de batterie (19) en état ouvert pour interrompre l'alimentation électrique provenant de l'unité de stockage d'énergie basse tension vers la première charge basse tension ; la commande de l'agencement de commutation (20) pour connecter temporairement la première section (25) d'un faisceau de câbles d'alimentation CC de véhicule avec le stockage d'énergie électrique dédié (18) pour générer un courant de mesure à travers la première section du faisceau de câbles d'alimentation CC de véhicule ; et la détermination d'une valeur de résistance de la première section (25) du faisceau de câbles d'alimentation CC de véhicule (22) sur la base du niveau de courant de mesure.

14. Procédé selon la revendication 13,

dans lequel le circuit électrique basse tension de véhicule a en outre une seconde charge basse tension (29) connectée à l'unité de stockage d'énergie basse tension (6) via le contacteur de batterie (19) et une seconde section (26) du faisceau de câbles d'alimentation CC de véhicule (22), dans lequel l'agencement de commutation (20) est configuré pour une connexion sélective du stockage d'énergie électrique dédié (18) avec la seconde section du faisceau de câbles d'alimentation CC de véhicule, dans lequel le procédé comprend :

la commande de l'agencement de commutation (20) pour connecter temporairement la seconde section (26) d'un faisceau de câbles d'alimentation CC de véhicule avec le stockage d'énergie électrique dédié (18) pour générer un courant de mesure à travers la seconde section du faisceau de câbles d'alimentation CC de véhicule, la détermination d'une valeur de résistance de la seconde section (26) du faisceau de câbles d'alimentation CC de véhicule sur la base du niveau de courant de mesure à travers la seconde section.

15. Procédé selon l'une quelconque des revendications précédentes 13 à 14, dans lequel le système électrique de véhicule comprend en outre :

un circuit électrique basse tension de véhicule redondant ayant une unité de stockage d'énergie basse tension redondante (6*) connectée à une première charge basse tension redondante (28*) via un contacteur de batterie (19*) et une première section (25*) d'un faisceau de câbles d'alimentation CC de véhicule redondant (23), un convertisseur CC/CC (9*) connecté au système de stockage électrique haute tension (5) et au circuit électrique basse tension de véhicule redondant, et configuré pour fournir de l'énergie électrique provenant du système de stockage électrique haute tension (5) au circuit électrique basse tension de véhicule redondant, dans lequel l'agencement de commutation (20) est configuré pour une connexion sélective du stockage d'énergie électrique dédié (18) avec une première section (25*) du faisceau de câbles d'alimentation CC de véhicule redondant (23)

dans lequel le procédé comprend :

le réglage du contacteur de batterie (19*) de l'unité de stockage d'énergie basse tension redondante (6*) en état ouvert pour interrompre l'alimentation électrique provenant de l'unité de stockage d'énergie basse tension redondante vers la première charge basse tension redondante ;

la commande de l'agencement de commutation (20) pour connecter temporairement la première section (25*) du faisceau de câbles d'alimentation CC de véhicule redondant (22) avec

le stockage d'énergie électrique dédié (18) pour générer un courant de mesure à travers la première section du faisceau de câbles d'alimentation CC de véhicule redondant ; et la détermination d'une valeur de résistance de la première section (25*) du faisceau de câbles d'alimentation CC de véhicule redondant (23) sur la base du niveau de courant de mesure.

FIG.1

FIG.2

FIG.3

FIG.4

FIG.5

FIG.6

FIG.7

FIG.8A

FIG.8B

FIG.9

FIG.10

FIG.11

FIG.12

FIG.13

FIG.14

FIG.15

FIG.16

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 110568264